# EUROPEAN PATENT APPLICATION

(11) **EP 4 621 522 A1**
(43) Date of publication of application: **24.09.2025**
(21) Application number: 24823700.0
(22) Date of filing: 12.06.2024
(51) Int. Cl.: G06F 1/16, H04M 1/02

(54) **HINGE MODULE AND ELECTRONIC DEVICE COMPRISING SAME**

(30) Priority: 12.06.2023 KR 20230075080; 19.09.2023 KR 20230124475
(71) Applicant: Samsung Electronics Co., Ltd., Suwon-si, Gyeonggi-do 16677 (KR)
(72) Inventor: KIM, Jongkeun, Suwon-si, Gyeonggi-do 16677 (KR); KANG, Jaeho, Suwon-si, Gyeonggi-do 16677 (KR); KIM, Jongyoon, Suwon-si, Gyeonggi-do 16677 (KR); KIM, Hyungsoo, Suwon-si, Gyeonggi-do 16677 (KR); BAIK, Jinwook, Suwon-si, Gyeonggi-do 16677 (KR); YUN, Sukjin, Suwon-si, Gyeonggi-do 16677 (KR); CHUNG, Haewoo, Suwon-si, Gyeonggi-do 16677 (KR); CHOI, Soobin, Suwon-si, Gyeonggi-do 16677 (KR); HAN, Yonghwa, Suwon-si, Gyeonggi-do 16677 (KR)
(74) Representative: Gulde & Partner
(86) International application number: PCT/KR2024/008069
(87) International publication number: WO 2024/258182

(57) **Abstract**

According to an embodiment of the present disclosure, a foldable electronic device including a hinge module may be provided. The foldable electronic device may comprise: a first housing; a second housing; a hinge module for coupling the first housing and the second housing so as to be rotatable about a folding axis; and a flexible display. The hinge module includes: a first rotation member; a first arm member which rotates in response to the rotation of the first axis with respect to an axis different from the first axis and the second axis; a first connection member for connecting the first rotation member and the first arm member; and a first wing plate positioned to cover at least a portion of the first rotation member and the first arm member and rotating according to a folding operation of the foldable electronic device. In addition, according to various other embodiments, a hinge module and a foldable electronic device including the same may be provided.

## Description

### [TECHNICAL FIELD]

Various embodiments of the disclosure relate to an electronic device, e.g., a hinge module and an electronic device including the same.

### [BACKGROUND ART]

The growth of electronics, information, and communication technologies leads to integration of various functions into a single electronic device. For example, smartphones pack the functionalities of a sound player, imaging device, and scheduler, as well as the communication functionality and, on top of that, may implement more various functions by having applications installed thereon.

As smartphones or other personal/portable electronic devices spread, users' demand for portability and use convenience is on the rise. For example, a touchscreen display may not only serve as an output device of visual information but also provide a virtual keyboard that replaces a physical input device (e.g., a keypad). To provide enhanced usability (e.g., larger screens), electronic devices including flexible, e.g., foldable or rollable displays have been commercially available.

The above-described information may be provided as background for the purpose of helping understanding of the disclosure. No claim or determination is made as to whether any of the foregoing is applicable as background art in relation to the disclosure.

### [DISCLOSURE OF INVENTION]

### [Solution to Problems]

According to an embodiment, a foldable electronic device including a hinge module may comprise a first housing, a second housing, a hinge module rotatably coupling the first housing and the second housing about a folding axis, and a flexible display. The hinge module may include a first rotating member including a first rotary element configured to rotate about a first axis, a second rotary element configured to rotate about a second axis, and a reciprocating element configured to linearly reciprocate at least a portion of a first wing plate in a direction perpendicular to the first axis and the second axis, a first arm member rotating about an axis different from the first axis and the second axis in response to rotation about the first axis, a first connecting member connecting the first rotating member and the first arm member. The first wing plate is positioned to cover at least a portion of the first rotating member and the first arm member and is configured to rotate according to a folding operation of the foldable electronic device.

According to an embodiment of the disclosure, a hinge module may be provided. A hinge module may comprise a first rotating member including a first rail configured to rotate about a first axis and shaped to be convex in a first direction, one of a second rail configured to rotate about a second axis and shaped to be convex in a second direction different from the first direction, or a first pin hole formed on the second axis, and a third rail having an opening shape, a rotating bracket including a first rotating guide hole configured to guide the first rail, a first arm member including a first cam portion configured to rotate about an axis different from the first axis and the second axis in response to rotation about the first axis and a first arm rail configured to slide in response to the rotation of the first cam portion, a first connecting member including a first guide rail configured to guide the second rail or a second pin hole aligned with the first pin hole, a second guide rail configured to guide the first arm rail, and a fourth rail, and a first wing plate positioned to cover at least a portion of the first rotating member and the first arm member and including a first protrusion configured to slide on the third rail and a second protrusion configured to slide on the fourth rail.

According to an embodiment, there may be provided a foldable electronic device including a hinge module. The foldable electronic device may include a first housing, a second housing, a hinge module rotatably coupling the first housing and the second housing about a folding axis, and a flexible display. The hinge module may include a first rotating member including a first rail configured to rotate about a first axis and shaped to be convex in a first direction, one of a second rail configured to rotate about a second axis and shaped to be convex in a second direction different from the first direction, or a first pin hole formed on the second axis, and a third rail having an opening shape, a second rotating member including a sixth rail configured to rotate about a third axis and shaped to be convex in a third direction, one of a seventh rail configured to rotate about a fourth axis and shaped to be convex in a fourth direction different from the third direction, or a third pin hole formed on the fourth axis, and an eighth rail having an opening shape, a first arm member configured to rotate about an axis different from the first axis and the second axis in response to rotation about the first axis, a second arm member configured to rotate about an axis different from the third axis and the fourth axis in response to rotation about the third axis, a first connecting member connecting the first rotating member and the first arm member, a second connecting member connecting the second rotating member and the second arm member, a first wing plate positioned to cover at least a portion of the first rotating member and the first arm member and configured to rotate according to a folding operation of the foldable electronic device, and a second wing plate positioned to cover at least a portion of the second rotating member and the second arm member and configured to rotate according to the folding operation of the foldable electronic device.

### [BRIEF DESCRIPTION OF DRAWINGS]

The foregoing and other aspects, configurations, and/or advantages of various embodiments of the disclosure will be more apparent from the following detailed description taken in conjunction with the accompanying drawings.
FIG. 1 is a view illustrating an unfolded state of an electronic device according to an embodiment of the disclosure;
FIG. 2 is a view illustrating a folded state of an electronic device according to an embodiment of the disclosure;
FIG. 3 is a perspective view illustrating an electronic device according to an embodiment of the disclosure;
FIG. 4 is a front view illustrating a state in which a hinge module is disposed on a lower surface of a display according to an embodiment of the disclosure;
FIG. 5 is a perspective view illustrating a hinge module according to an embodiment of the disclosure;
FIG. 6 is an exploded perspective view illustrating a hinge module according to an embodiment of the disclosure;
FIG. 7 is a perspective view illustrating a hinge module according to an embodiment of the disclosure;
FIG. 8A is a perspective view illustrating a rotating member according to an embodiment of the disclosure;
FIG. 8B is a front view illustrating a rotating member according to an embodiment of the disclosure;
FIG. 8C is a view illustrating a rotating member viewed from thereabove, according to an embodiment of the disclosure;
FIG. 8D is a view illustrating a surface where a wing plate is mounted and a cross section of a third rail in a rotating member according to an embodiment of the disclosure;
FIG. 9A is a perspective view illustrating a connecting member according to an embodiment of the disclosure;
FIG. 9B is a view illustrating a connecting member viewed from thereabove, according to an embodiment of the disclosure;
FIG. 9C is a view illustrating a fourth rail of a connecting member according to an embodiment of the disclosure;
FIG. 10A is a view illustrating an arm member viewed from thereabove, according to an embodiment of the disclosure;
FIG. 10B is a front view illustrating an arm member according to an embodiment of the disclosure;
FIG. 11 is a perspective view illustrating a wing plate according to an embodiment of the disclosure;
FIG. 12A is a view illustrating a hinge module except for a wing plate according to an embodiment of the disclosure;
FIG. 12B is a view illustrating a hinge module including a wing plate according to an embodiment of the disclosure;
FIG. 13A is a perspective view illustrating a hinge module in an unfolded state of an electronic device according to an embodiment of the disclosure;
FIG. 13B is a cross-sectional view illustrating a hinge module in an unfolded state of an electronic device according to an embodiment of the disclosure;
FIG. 14A is a perspective view illustrating a hinge module in an intermediate state of an electronic device according to an embodiment of the disclosure;
FIG. 14B is a cross-sectional view illustrating a hinge module in an intermediate state of an electronic device according to an embodiment of the disclosure;
FIG. 15A is a perspective view illustrating a hinge module in a folded state of an electronic device according to an embodiment of the disclosure;
FIG. 15B is a cross-sectional view illustrating a hinge module in a folded state of an electronic device according to an embodiment of the disclosure;
FIG. 16A is a view illustrating a hinge module in an unfolded state of an electronic device according to an embodiment of the disclosure;
FIG. 16B may show a cross-section taken along direction A-A' of the hinge module of FIG. 16A according to an embodiment of the disclosure;
FIG. 16C may show a cross-section taken along direction D-D' of the hinge module of FIG. 16A according to an embodiment of the disclosure;
FIG. 17A is a view illustrating a hinge module in a folded state of an electronic device according to an embodiment of the disclosure;
FIG. 17B may show a cross-section taken along direction A-A' of the hinge module of FIG. 17A according to an embodiment of the disclosure;
FIG. 17C may show a cross-section taken along direction D-D' of the hinge module of FIG. 17A according to an embodiment of the disclosure;
FIG. 18A is a view illustrating a hinge module in an unfolded state of an electronic device according to an embodiment of the disclosure;
FIG. 18B may show a cross-section taken along direction B-B' of the hinge module of FIG. 18A according to an embodiment of the disclosure;
FIG. 18C may show a cross-section taken along direction C-C' of the hinge module of FIG. 18A according to an embodiment of the disclosure;
FIG. 19A is a view illustrating a hinge module when an electronic device is in an intermediate state between an unfolded state and a folded state according to an embodiment of the disclosure;
FIG. 19B may show a cross-section taken along direction B-B' of the hinge module of FIG. 19A according to an embodiment of the disclosure;
FIG. 19C may show a cross-section taken along direction C-C' of the hinge module of FIG. 19A according to an embodiment of the disclosure;
FIG. 20A is a view illustrating a hinge module in a folded state of an electronic device according to an embodiment of the disclosure;
FIG. 20B may show a cross-section taken along direction B-B' of the hinge module of FIG. 20A according to an embodiment of the disclosure;
FIG. 20C may show a cross-section taken along direction C-C' of the hinge module of FIG. 20A according to an embodiment of the disclosure;
FIG. 21A is a view illustrating a hinge module in an unfolded state of an electronic device according to an embodiment of the disclosure;
FIG. 21B is a view illustrating a hinge module in a folded state of an electronic device according to an embodiment of the disclosure;
FIG. 22A is a view illustrating a hinge module in an unfolded state of an electronic device according to an embodiment of the disclosure;
FIG. 22B is a view illustrating a hinge module in a folded state of an electronic device according to an embodiment of the disclosure;
FIG. 23A is a perspective view illustrating a rotating member according to an embodiment of the disclosure;
FIG. 23B is a perspective view illustrating a rotating member according to an embodiment of the disclosure;
FIG. 24A is a perspective view illustrating a connecting member according to an embodiment of the disclosure;
FIG. 24B is a view illustrating a connecting member viewed from a side, according to an embodiment of the disclosure;
FIG. 24C is a view illustrating a connecting member viewed from the rear, according to an embodiment of the disclosure;
FIG. 25A is a perspective view illustrating a state in which a rotating member and a connecting member are coupled according to an embodiment of the disclosure; and
FIG. 25B is a view illustrating a state in which a rotating member and a connecting member are coupled according to an embodiment of the disclosure.

Throughout the drawings, like reference numerals may be assigned to like parts, components, and/or structures.

### [MODE FOR THE INVENTION]

The following description with reference to the accompanying drawings is provided to assist in a comprehensive understanding of various embodiments of the disclosure as defined by the claims and their equivalents. It includes various specific details to assist in that understanding but these are to be regarded as merely exemplary. Accordingly, those of ordinary skill in the art will recognize that various changes and modifications of the various embodiments described herein can be made without departing from the scope and spirit of the disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

In a foldable electronic device including a flexible display, reducing and/or preventing creases of the display is a major issue. To address such issue, design of the hinge module may be critical. U-shaped hinge modules and dumbbell-shaped hinge modules have been known. In the U-shaped hinge module, the components are spread in the U shape to face each other. The dumbbell-shaped (or water drop shape) hinge module includes components that form a negative angle (e.g., -5 degrees) in the folded state. It is known that the dumbbell-shaped hinge module is effective in reducing creases and is advantageous in mitigate delamination at the portion where the screens contact each other, as compared with the U-shaped hinge module.

The dumbbell-shaped hinge module may require laned back motion of the portion (e.g., a plate) supporting the display to provide a space where the display is bendable in the folded state of the electronic device while supporting the display in the unfolded state of the electronic device. The conventional dumbbell-shaped hinge module has a rotating rail structure at the portion supporting the display, as a component for implementing leaned back motion, and the rotating rail structure may occupy a space in the width direction of the electronic device. Further, the rotating rail structure may limit an effective arrangement of components of the electronic device.

The disclosure provides various embodiments capable of substantially expanding the area for arranging components while enhancing the operation structure of the hinge module in a foldable electronic device including a dumbbell-shaped hinge module.

Objects of the disclosure are not limited to the foregoing, and other unmentioned objects would be apparent to one of ordinary skill in the art from the following description.

Hereinafter, embodiments of the present disclosure are described with reference to the accompanying drawings.

The electronic device according to various embodiments may be one of various types of devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

According to an embodiment of the disclosure, each component (e.g., a module or a program) of the above-described components may include a single entity or multiple entities. Some of the plurality of entities may be separately disposed in different components. According to an embodiment of the disclosure, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

It should be appreciated that the blocks in each flowchart and combinations of the flowcharts may be performed by one or more computer programs which include computer-executable instructions. The entirety of the one or more computer programs may be stored in a single memory device or the one or more computer programs may be divided with different portions stored in different multiple memory devices.

Any of the functions or operations described herein can be processed by one processor or a combination of processors. The one processor or the combination of processors is circuitry performing processing and includes circuitry like an application processor (AP, e.g., a central processing unit (CPU)), a communication processor (CP, e.g., a modem), a graphical processing unit (GPU), a neural processing unit (NPU) (e.g., an artificial intelligence (AI) chip), a wireless-fidelity (Wi-Fi) chip, a Bluetooth^{™} chip, a global positioning system (GPS) chip, a near field communication (NFC) chip, connectivity chips, a sensor controller, a touch controller, a finger-print sensor controller, a display driver integrated circuit (IC), an audio CODEC chip, a universal serial bus (USB) controller, a camera controller, an image processing IC, a microprocessor unit (MPU), a system on chip (SoC), an IC, or the like.

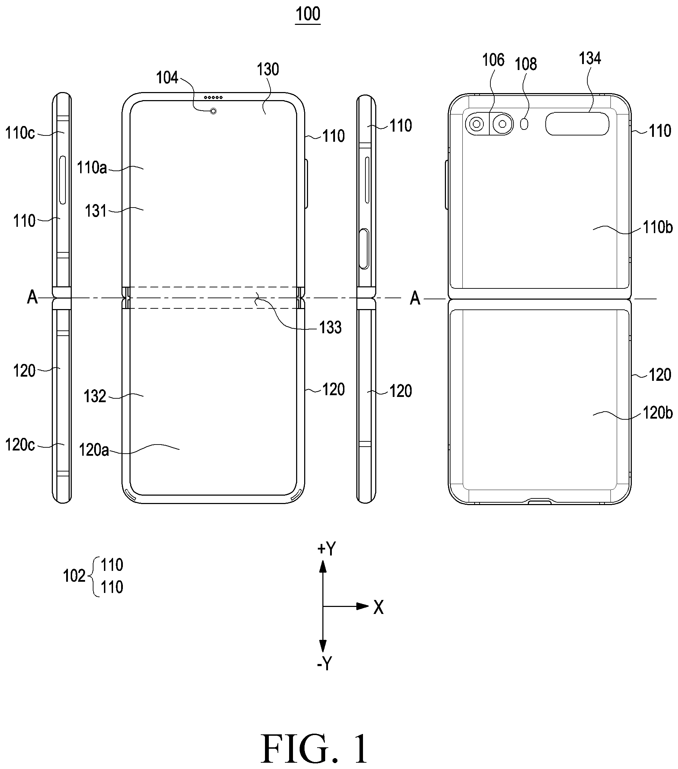

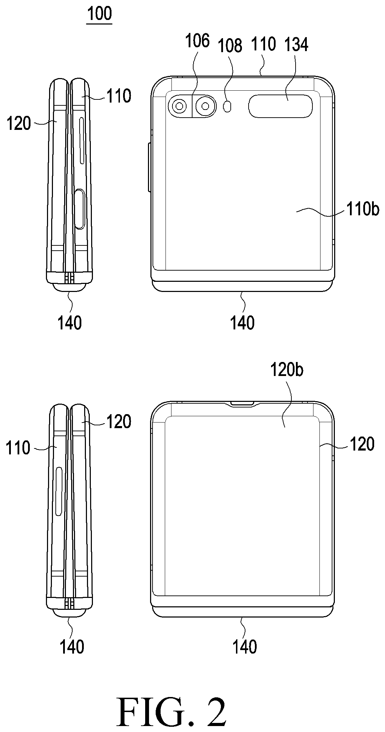

FIG. 1 is a view illustrating an unfolded state of an electronic device according to an embodiment of the disclosure. FIG. 2 is a view illustrating a folded state of an electronic device according to an embodiment of the disclosure.

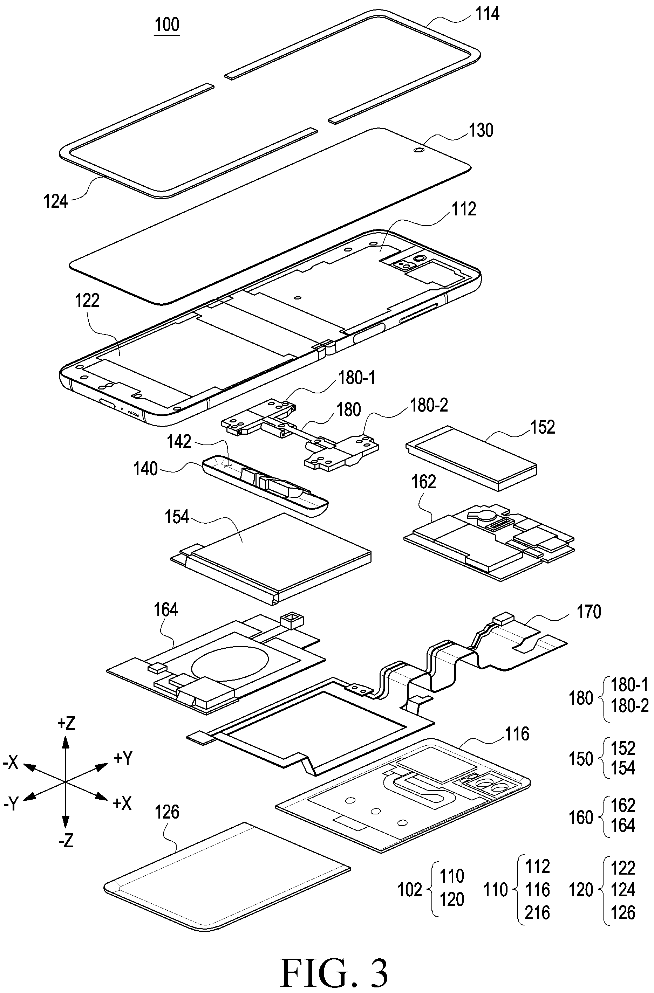

Referring to FIGS. 1 and 2, an electronic device 100 may include a foldable housing 102 (hereinafter, referred to as a housing 102) for receiving components (e.g., the hinge module 180 of FIG. 3) of the electronic device 100 and a flexible or foldable display 130 (hereinafter, referred to as a "display" 130) disposed in a space formed by the housing 102.

According to an embodiment, the housing 102 may include a first housing 110 and a second housing 120.

According to an embodiment, the first housing 110 and/or the second housing 120 may form a portion of the exterior of the electronic device 100. According to an embodiment, the surface where the display 130 is visually exposed is defined as a front surface (e.g., a first front surface 110a and a second front surface 120a) of the electronic device 100 and/or housing 102. A surface opposite to the front surface is defined as a rear surface (e.g., a first rear surface 110b and a second rear surface 120b) of the electronic device 100. Further, a surface surrounding at least a portion of the space between the front surface and the rear surface is defined as a side surface (e.g., the first side surface 110c and the second side surface 120c) of the electronic device 100.

According to an embodiment, the first housing 110 may be rotated about the second housing 120 by a hinge module (e.g., the hinge module 180 of FIG. 3). Thus, the electronic device 100 may turn into a folded state (e.g., FIG. 2) or unfolded state (e.g., FIG. 1). In the folded state of the electronic device 100, the first front surface 110a may face the second front surface 120a and, in the unfolded state, the direction in which the first front surface 110a faces may be the same as the direction in which the second front surface 120a faces. For example, in the unfolded state, the first front surface 110a may be positioned on substantially the same plane as the second front surface 120a. According to an embodiment, the first housing 110 may provide a motion relative to the second housing 120, and the second housing 120 may provide a motion relative to the first housing 110.

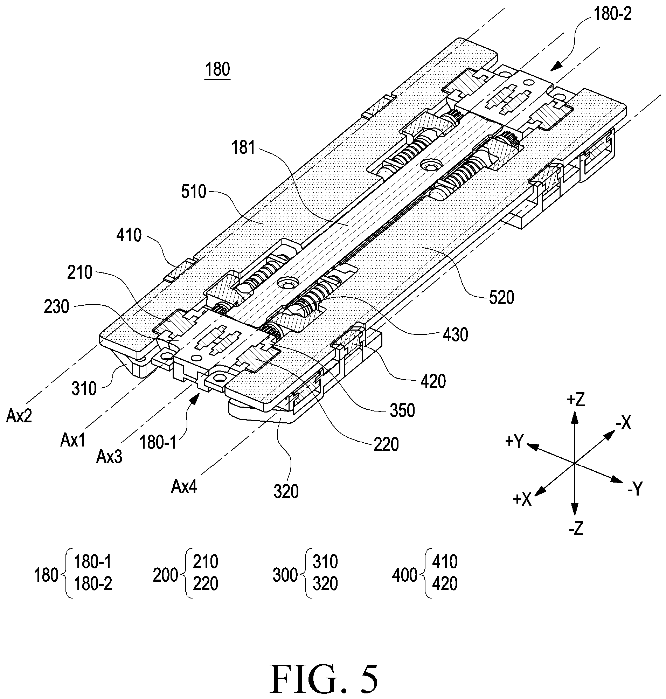

According to an embodiment, the first housing 110 and the second housing 120 are disposed on both sides of the folding axis A and be overall symmetrical in shape with respect to the folding axis A. As described below, the angle between the first housing 110 and the second housing 120 may be changed depending on whether the electronic device 100 is in the unfolded state, the folded state, or an intermediate state between the unfolded state and the folded state. According to an embodiment, the folding axis A may be a virtual axis positioned between (e.g., in the middle) between a first axis (e.g., the first axis Ax1 of FIG. 5) and a third axis (e.g., the third axis Ax3 of FIG. 5). In an embodiment, the first housing 110 and the second housing 120 may rotate on the hinge module 180 about different folding axes. For example, the first housing 110 and the second housing 120 each may be rotatably coupled to the hinge module 180, and may be rotated on the folding axis A or different folding axes to rotate from the position where they are folded together to the position where they are inclined or unfolded side-by-side with respect to each other.

As used herein, "positioned side by side with respect to each other" or "extending side by side with respect to each other" may mean a state in which the two structures (e.g., the housing structures 110 and 120) are at least partially positioned next to each other, or at least their respective portions that are next to each other are disposed parallel to each other. In an embodiment, "disposed side by side with respect to each other" may mean that the two structures are positioned next to each other while facing in the same direction or directions parallel to each other. In the following detailed description, the expressions "side by side" and "parallel" may be used, but will be readily understood based on the shapes and arrangement of the structures with reference to the attached drawings.

According to an embodiment, the electronic device 100 may include a hinge housing 140. The hinge housing 140 may be disposed between the first housing 110 and the second housing 120. According to an embodiment, the hinge housing 140 may be hidden by a portion of the first housing 110 and second housing 120 or be exposed to the outside depending on the state of the electronic device 100. According to an embodiment, the hinge housing 140 may protect the hinge module (e.g., the hinge module 180 of FIG. 3) from an external impact of the electronic device 100. According to an embodiment, the hinge housing 140 may be interpreted as a hinge cover for protecting the hinge module 180.

According to an embodiment, the first housing 110 and the second housing 120 may form different angles or distances depending on whether the electronic device 100 is in an unfolded state (or extended state, flat state, or opened state), a folded state (or closed state), or an intermediate state.

According to an embodiment, as shown in FIG. 1, in the unfolded state of the electronic device 100, the hinge housing 140 may be hidden, and thus not exposed, by the first housing 110 and the second housing 120. According to an embodiment, as shown in FIG. 2, in the folded state (e.g., a fully folded state) of the electronic device 100, the hinge housing 140 may be exposed to the outside between the first housing 110 and the second housing 120. According to an embodiment, in an intermediate state in which the first housing 110 and the second housing 120 are folded with a certain angle, the hinge housing 140 may be partially exposed to the outside between the first housing 110 and the second housing 120. However, in this case, the exposed area may be smaller than that in the completely folded state. In an embodiment, the hinge housing 140 may include a curved surface.

According to an embodiment, the display 130 may mean a display at least a portion of which may be transformed into a flat or curved surface. For example, the display 130 may be formed to be transformable in response to the motion of the second housing 120 relative to the first housing 110. According to an embodiment, the display 130 may include a folding area 133, a first display area 131 disposed on one side of the folding area 133 (e.g., above the folding area 133 (in the +Y direction) of FIG. 1), and a second display area 132 disposed on the other side of the folding area 203 (e.g., under the folding area 133 (in the -Y direction) of FIG. 1). According to an embodiment, the folding area 133 may be formed over the hinge module (e.g., the hinge module 180 of FIG. 3). According to an embodiment, the first display area 131 may be disposed on the first housing 110, and the second display area 132 may be disposed on the second housing 120. According to an embodiment, the display 130 may be received in the first housing 110 and the second housing 120.

However, the segmentation of the display 130 as shown in FIG. 1 is merely an example, and the display 130 may be divided into a plurality of (e.g., four or more, or two) areas depending on the structure or function of the display 200. For example, in the embodiment illustrated in FIG. 1, the display 130 may be divided into the areas by the folding area 133 or folding axis (axis A) extending in parallel with the X axis but, in an embodiment, the display 130 may be divided into the areas with respect to another folding area (e.g., a folding area parallel with the X axis) or another folding axis (e.g., a folding axis parallel with the X axis). According to an embodiment, the display 130 may be coupled with or disposed adjacent to a touch detection circuit, a pressure sensor capable of measuring the strength (pressure) of touches, and/or a digitizer for detecting a magnetic field-type stylus pen.

According to an embodiment, the electronic device 100 may include a rear display 134. The rear display 134 may be disposed to face in a different direction from the display 130. For example, the display 130 may be visually exposed through the front surface (e.g., the first front surface 110a and/or the second front surface 120a) of the electronic device 100, and the rear display 134 may be visually exposed through the rear surface (e.g., the first rear surface 110b) of the electronic device 100.

According to an embodiment, the electronic device 100 may include at least one camera 104 and 106 and a flash 108. According to an embodiment, the electronic device 100 may include a front camera 104 exposed through the front surface (e.g., the first front surface 110a) and/or a rear camera 106 exposed through the rear surface (e.g., the first rear surface 110b). The cameras 104 and 106 may include one or more lenses, an image sensor, a flash, and/or an image signal processor. The flash 108 may include, e.g., a light emitting diode or a xenon lamp. According to an embodiment, two or more lenses (an infrared (IR) camera, a wide-angle lens, and a telephoto lens) and image sensors may be disposed on one surface of the electronic device 100.

Described below are the operation of the first housing 110 and the second housing 120 and each area of the display 130 depending on the operation state (e.g., the unfolded state (extended state) and folded state) of the electronic device 100.

In an embodiment, when the electronic device 100 is in the unfolded state (extended state) (e.g., the state in FIG. 1), the first housing 110 and the second housing 120 form an angle of 180 degrees, and the first surface 110a and the second surface 120a of the display may be disposed to face in the same direction, e.g., to display the screen in directions parallel to each other. Further, the folding area 133 may be coplanar with the first surface 110a and the second surface 120a. In describing various embodiments of the disclosure, when the state of the electronic device 100 is the "unfolded state", it may mean a "fully unfolded state" in which the angle between the first housing 110 and the second housing 120 of the electronic device is 180 degrees.

According to an embodiment, when the electronic device 100 is in the folded state (e.g., the state in FIG. 2), the first housing 110 and the second housing 120 may be disposed to face each other. For example, when the electronic device 100 is in the folded state (e.g., the state in FIG. 2), the first surface 110a and the second surface 131b of the display 130 may face each other while forming a narrow angle (e.g., an angle between 0 and 10 degrees) therebetween. When the electronic device 100 is in the folded state (e.g., the state of FIG. 2), at least a portion of the folding area 133 may form a curved surface having a predetermined curvature. When the state of the electronic device 100 is the "closed state", it may mean a state in which the angle between the first housing 110 and the second housing 120 of the electronic device is 0 degrees or an angle within 10 degrees.

In an embodiment, in the intermediate state of the electronic device 100, the first housing 110 and the second housing 120 may be arranged at a certain angle, e.g., 90 degrees or 120 degrees, therebetween. For example, in the intermediate state, the first surface 110a and the second surface 120a of the display 130 may form an angle which is larger than the angle in the folded state and smaller than the angle in the unfolded state. The folding area 133 may at least partially have a curved surface with a predetermined curvature and, in this case, the curvature may be smaller than that when it is in the folded state. When the state of the electronic device 100 is the "intermediate state", it may mean a state of forming an angle between the angle between the first housing 110 and the second housing 120 in the "unfolded state" and the angle between the first housing 110 and the second housing 120 in the "closed state".

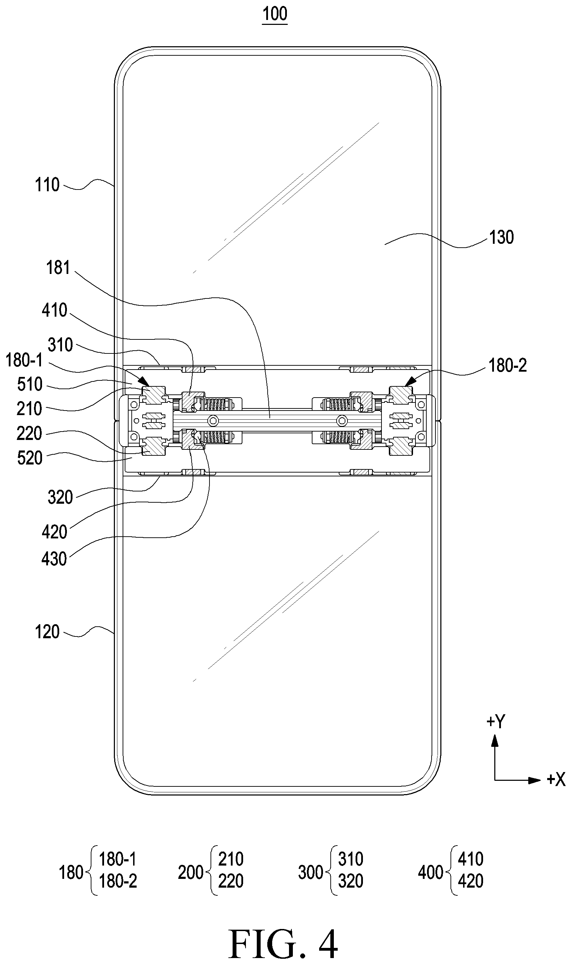

FIG. 3 is a perspective view illustrating an electronic device according to an embodiment of the disclosure. FIG. 4 is a front view illustrating a state in which a hinge module is disposed on a lower surface of a display according to an embodiment of the disclosure. FIG. 5 is a perspective view illustrating a hinge module according to an embodiment of the disclosure.

In the following detailed description, the length direction of the electronic device 100 may be defined as the 'Y-axis direction', the width direction as the 'X-axis direction', and/or the height direction (the thickness direction) as the 'Z-axis direction'. In the following detailed description, the mentioned length direction, width direction, and/or height direction (or thickness direction) may indicate the length direction, the width direction, and/or the height direction (or thickness direction) of the electronic device. In an embodiment, 'negative/positive (-/+)' may be mentioned together with the Cartesian coordinate system exemplified in the drawings with respect to the direction in which the component is oriented. For example, referring to FIG. 3, the front surface of the electronic device 100 or housing 102 may be defined as a 'surface facing in the +Z direction,' and the rear surface may be defined as a 'surface facing in the -Z direction'. According to an embodiment, the arrangement relationship in the height direction of a component or another component, for example, , the reference as to whether a component is on/under another component, may follow the +Z-axis direction/-Z-axis direction. For example, when a component is disposed on another component, it may mean that the component is disposed on the +Z-axis direction with respect to the other component, and when a component is disposed under another component, it may mean that the component is disposed on the -Z-axis direction with respect to the other component. Meanwhile, it should be noted that although a component is disposed on or under another component, it does not necessarily mean that the entire component is disposed on or under the entire other component. For example, it should be noted that a portion of the component may be disposed on a portion of the other component while another portion of the component may be disposed under another portion of the other component. According to an embodiment, when a component is viewed from thereabove, it may mean that the component is viewed from the +Z-axis direction to the -Z-axis direction from a place a predetermined distance away from the component. According to an embodiment, when a component is viewed in the width direction of the electronic device, it may mean that the component is viewed from the -Z-axis direction to the +Z-axis direction from a place a predetermined distance away from the component. According to an embodiment, when a component faces in a certain direction, it may be understood as including when the component faces in a direction parallel to the certain direction as well as when the component faces in the same direction as the certain direction. In the following description, it should be noted that when a component overlaps (or is stacked on) another component, the above description of the arrangement relationship in height direction may apply. In describing the direction, when 'negative/positive (-/+)' is not described, it may be interpreted as including both the + direction and the - direction unless separately defined. For example, the 'Z-axis direction' may be interpreted as including both the +Z direction and the - Z direction. Likewise, 'X-axis direction' may be interpreted as including both +X direction and -X direction, and 'Y-axis direction' may be interpreted as including both +Y direction and -Y direction. In describing directions, facing in any one axis among the three axes of the orthogonal coordinate system may include facing in a direction parallel to the axis. Hereinafter, in the following description, 'first direction' may mean the -Z-axis direction or a direction parallel to the -Z axis, and 'second direction' may mean the +Z-axis direction or a direction parallel to the +Z axis. It should be noted that the directions are so defined with respect to the Cartesian coordinate system shown in the drawings for the sake of brevity of description, and the description of these directions or components do not limit various embodiments of the disclosure.

Referring to FIGS. 3 and 4, an electronic device 100 may include a housing 102 including a first housing 110 and a second housing 120, a display 130, a hinge housing 140, a battery 150, a printed circuit board 160, a flexible printed circuit board 170, and a hinge module 180. The configuration of the first housing 110, the second housing 120, the display 130, and the hinge housing 140 of FIGS. 3 and 4 may be identical in whole or part to the configuration of the first housing 110, the second housing 120, the display 130, and the hinge housing 140 of FIGS. 1 and 2.

According to an embodiment, the housing 102 may include a first supporting member 112 or a second supporting member 122. For example, the first housing 110 may include a first supporting member 112, and the second housing 120 may include a second supporting member 122. According to an embodiment, the first supporting member 112 and/or the second supporting member 122 may support components (e.g., the display 130, the battery 150, and the printed circuit board 160) of the electronic device 100. According to an embodiment, the first supporting member 112 and the second supporting member 122, respectively, may be referred to as a 'first supporting bracket or a first front' and a 'second supporting bracket or a second front'.

According to an embodiment, the first supporting member 112 and/or the second supporting member 122 may be formed of a metal material and/or a non-metal (e.g., polymer) material. According to an embodiment, the first supporting member 112 may be disposed between the display 130 and the battery 150. For example, the display 130 may be coupled to one surface of the first supporting member 112, and the battery 150 and the printed circuit board 160 may be disposed on the other surface.

According to an embodiment, the housing 102 may include a first deco member 114 and a second deco member 124. For example, the first housing 110 may include the first deco member 114, and the second housing 120 may include the second deco member 124. According to an embodiment, the deco members 114 and 124 may protect the display 130 from external impact. For example, the first deco member 114 may surround at least a portion of a portion (e.g., the first display area 131 of FIG. 1) of the display 130, and the second deco member 124 may surround at least a portion of another portion (e.g., the second display area 132 of FIG. 1) of the display 130.

According to an embodiment, the housing 102 may include a first rear plate 116 and a second rear plate 126. For example, the first housing 110 may include a first rear plate 116 connected to the first supporting member 112, and the second housing 120 may include a second rear plate 126 connected to the second supporting member 122. According to an embodiment, the rear plates 116 and 126 may form at least a portion of the exterior of the electronic device 100. For example, the first rear plate 116 may form a first rear surface (e.g., the first rear surface 110b of FIG. 1), and the second rear plate 126 may form a second rear surface (e.g., the second rear surface 120b of FIG. 1). According to an embodiment, the first battery 152 and the first printed circuit board 162 may be disposed between the first supporting member 112 and the first rear plate 116. The second battery 154 and the second printed circuit board 164 may be disposed between the second supporting member 122 and the second rear plate 126.

According to an embodiment, the hinge housing 140 may receive at least a portion of the hinge module 180. For example, the hinge housing 140 may include a receiving recess 142 for receiving the hinge module 180. According to an embodiment, the hinge housing 140 may be coupled to the hinge module 180. According to an embodiment, in the unfolded state of the electronic device 100, at least a portion of the hinge housing 140 may be positioned between the hinge module 180 and the housing 102.

According to an embodiment, the battery 150 may be a device for supplying power to at least one component of the electronic device 100. The battery 189 may include a primary cell which is not rechargeable, a secondary cell which is rechargeable, or a fuel cell. The battery 150 may be integrally or detachably disposed inside the electronic device 100. According to an embodiment, the battery 150 may include a first battery 152 disposed in the first housing 110 and a second battery 154 disposed in the second housing 120. For example, the first battery 152 may be disposed on the first supporting member 112. The second battery 154 may be disposed on the second supporting member 122.

According to an embodiment, a processor, a memory, and/or an interface may be mounted on the printed circuit board 160. The processor may include one or more of, e.g., a central processing unit, an application processor, a graphic processing device, an image signal processing, a sensor hub processor, or a communication processor. The memory may include a volatile or non-volatile memory. The interface may include, e.g., a high definition multimedia interface (HDMI), a universal serial bus (USB) interface, a secure digital (SD) card interface, and/or an audio interface. The interface may electrically or physically connect, e.g., the electronic device 100 with an external electronic device and may include a USB connector, an SD card/multimedia card (MMC) connector, or an audio connector. According to an embodiment, the printed circuit board 160 may include a first printed circuit board 162 disposed in the first housing 110 and a second printed circuit board 164 disposed in the second housing 120.

According to an embodiment, the flexible printed circuit board 170 may electrically connect a component (e.g., first printed circuit board 162) positioned in the first housing 110 with a component (e.g., second printed circuit board 164) positioned in the second housing 120. According to an embodiment, the flexible printed circuit board 170 may cross the hinge housing 140. For example, a portion of the flexible printed circuit board 170 may be disposed in the first housing 110, and another portion thereof may be disposed in the second housing 120. According to an embodiment, the flexible printed circuit board 170 may include a first flexible printed circuit board 172 connected to an antenna and a second flexible printed circuit board 174 connected to the display 130.

According to an embodiment, the hinge module 180 may be connected to the first housing 110 and the second housing 120. According to an embodiment, the first housing 110 may rotate about the second housing 120 by the hinge module 180. For example, the first housing 110 may rotate about an axis parallel to the width direction of the electronic device (e.g., hereinafter, the first axis Ax1 of FIG. 5), and the second housing 120 may rotate about another axis (e.g., hereinafter, the third axis Ax3 of FIG. 5) parallel to the axis where the first housing 110 and/or the first rotating member 210 rotates. According to an embodiment, the hinge module 180 may rotatably connect the first housing 110 and the second housing 120 from a folded state (e.g., FIG. 2) to an unfolded state (e.g., FIG. 1). According to an embodiment, the hinge module 180 may include a plurality of hinge modules 180-1 and 180-2 disposed in parallel. For example, the hinge modules 180 may include a first hinge module 180-1 disposed on the hinge housing 140 and a second hinge module 180-2 disposed on the opposite side of the first hinge module 180-1 with respect to the center bar 181. According to an embodiment, the first hinge module 180-1 may be symmetrical with the second hinge module 180-2 with respect to a virtual line drawn in the length direction (e.g., the Y-axis direction) of the electronic device 100. Hereinafter, The description of the electronic device 100 including the hinge module 180 of the disclosure focuses primarily on the first hinge module 180-1, but may also apply to the second hinge module 180-2.

Referring to FIGS. 4 and 5, According to an embodiment, the hinge module 180 may include a rotating member 200, a connecting member 300, an arm member 400, and/or a wing plate 500. According to an embodiment, only the components of the rotating member 200, the connecting member 300, and the arm member 400 other than the wing plate 500 may be referred to as the hinge module.

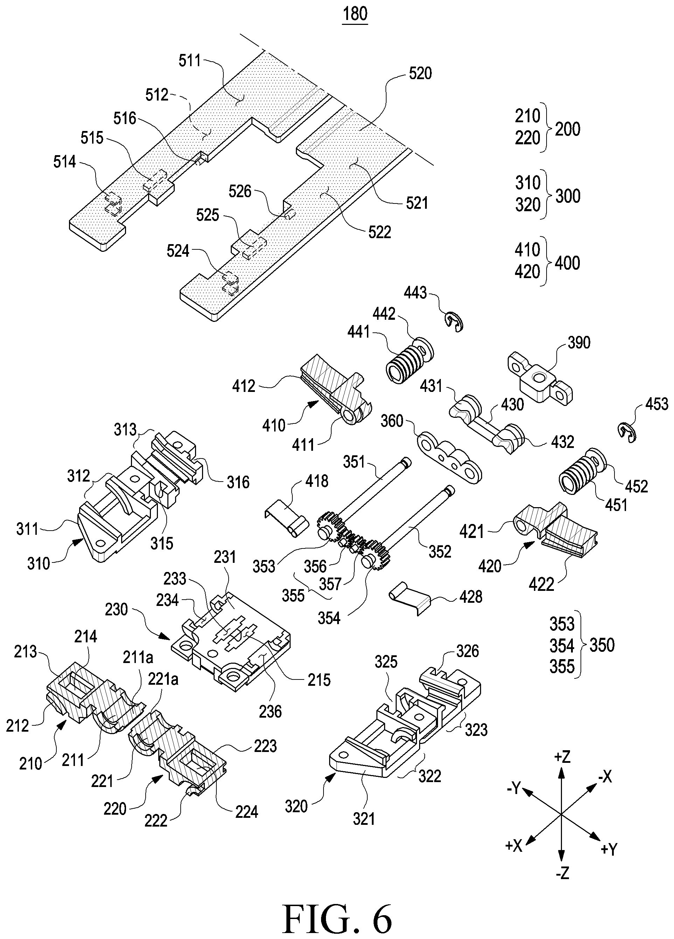

The rotating member 200 is a component capable of rotating about two axes, and may implement and/or guide a rotation operation of the first housing 110 and/or the second housing 120 as the rotating member 200 rotates. According to an embodiment, the rotating member 200 may include a first rotating member 210 that rotates along one axis (the first axis Ax1) to implement a rotation operation of the first housing 110, and a second rotating member 220 that rotates along the other axis (the third axis Ax3) to implement a rotation operation of the second housing 120. The first rotating member 210 may include two rotary elements (e.g., hereinafter, the first rail 211 and the second rail 212 of FIG. 6) configured to be movable about different axes, one (e.g., hereinafter, the first rail 211 of FIG. 6) of which may be configured to rotate about one axis (the first axis Ax1), and the other rotary element (e.g., hereinafter, the second rail 212 of FIG. 6) may be configured to rotate about a separate axis (the second axis Ax2) so that the display 130 may be naturally folded. The second rotating member 220 may include two rotary elements (e.g., hereinafter, the sixth rail 221 and the seventh rail 222 of FIG. 6) configured to be movable about different axes, one (e.g., hereinafter, the sixth rail 221 of FIG. 6) of which may be configured to rotate about the axis (the third axis Ax3), and the other rotary element (e.g., hereinafter, the seventh rail 222 of FIG. 6) may be configured to rotate about a separate axis (the fourth axis Ax4) so that the display 130 may be naturally folded. Further, the wing plate 500 is disposed on one surface (e.g., the first seating surface 213 or the second seating surface 223 of FIG. 6) of the rotating member 200, and another rail (e.g., the third rail 214 or the eighth rail 224 of FIG. 6) may be formed on the rotating member 200 to guide the wing plate 500 to slide linearly with respect to the rotating member 200.

The connecting member 300 is a component including two guide rails, and may be supported on one side by a supporting member (e.g., the first supporting member 112 or the second supporting member 122 of FIG. 3) included in the electronic device 100, and may have the other side to connect the rotating member 200 and the arm member 400. For example, the connecting member 300 is a component shaped so that it is relatively long in the width direction ((e.g., the e.g., X-axis direction-axis direction)) of the electronic device, relatively short in the length direction (e.g., the Y-axis direction) of the electronic device, and relatively thin in the height direction (e.g., the Z-axis direction-axis direction) of the electronic device and may have the supporting member (e.g., the first supporting member 112 or the second supporting member 122) coupled to a lower surface thereof, and the rotating member 200 and the arm member 400 disposed on an upper surface thereof along the width direction (e.g., the X-axis direction) of the electronic device. In this case, the rotating member 200 and the arm member 400 may be disposed parallel to each other in the length direction (e.g., the Y-axis direction) of the electronic device on substantially the same plane.

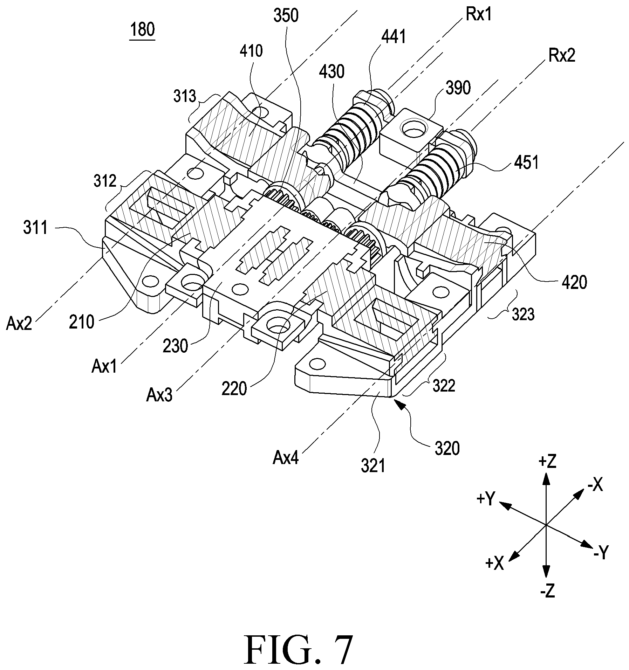

The arm member 400 is a component including a cam shape, and may rotate about an interlocking axis (hereinafter, referred to as the first interlocking axis Rx1 and the third interlocking axis Rx3 of FIG. 7) parallel to an axis (e.g., the first axis Ax1 or the third axis Ax3) in response to rotation of the rotating member 200 on the axis (e.g., the first axis Ax1 or the third axis Ax3). According to an embodiment, the electronic device 100 may perform a detent motion in which the first housing 110 and the second housing 120 are stopped at every predetermined angle with respect to each other by the arm member 400. For example, the arm member 400 may allow the first housing 110 and the second housing 120 to be maintained at a certain angle and, in this case, the cam of the arm member 400 may serve as a resistance element that does not allow rotation unless an external force (e.g., a detent force) of a predetermined value or more is applied.

According to an embodiment, the connecting member 300 may include a first connecting member 310 and a second connecting member 320. The arm member 400 may include a first arm member 410 and a second arm member 420. The first connecting member 310 may connect the first rotating member 210 and the first arm member 410, and the second connecting member 320 may connect the second rotating member 220 and the second arm member 420. According to an embodiment, the first arm member 410 and the second arm member 420 included in the arm member 400 each may be engaged with and coupled to the cam member 430. When the user applies an external force larger than or equal to a predetermined value to fold the electronic device 100, the arm member 400 may be disengaged from the cam member 430 to allow rotation of the first housing 110 and/or the second housing 120. When no external force is applied or an external force less than a predetermined value is applied, engagement between the arm member 400 and the cam member 430 may be maintained to keep the first housing 110 and/or the second housing 120 in a stationary state.

The wing plate 500 is a component having an overall flat shape, and may support a portion (e.g., a reverse curvature portion) of the display 130 when the electronic device 100 changes from one of the folded state, the intermediate state between the folded state and the unfolded state, and the unfolded state to another state. According to an embodiment, the wing plate 500 may be disposed on one surface of the rotating member 200 and may be formed to be slidable while remaining parallel to one surface of the rotating member 200. The wing plate 500 may include a first wing plate 510 and a second wing plate 520. The first wing plate 510 may be disposed to cover at least a portion of the first rotating member 210, and the second wing plate 520 may be disposed to cover at least a portion of the second rotating member 220. According to another embodiment, the first wing plate 510 may be disposed to cover at least a portion of the first arm member 410 as well as the first rotating member 210, and the second wing plate 520 may be disposed to cover at least a portion of the second arm member 420 as well as the second rotating member 220.

Referring to FIG. 5, the rotating bracket 230 is a component whose position is fixed on an imaginary line drawn from the axis of the center bar 181, and have one side where the first rail 211 of the first rotating member 210 may be rotatably inserted, and the other side where the sixth rail 221 of the second rotating member 220 may be rotatably inserted. The first rotating member 210 and the second rotating member 220 may be coupled to the rotating bracket 230 to be rotatable about the first axis Ax1 and the third axis Ax3, respectively. The first rotating member 210 and the second rotating member 220 may be configured to be rotatable about the first axis Ax1 and the third axis Ax3, respectively, with respect to the rotating bracket 230, while the first rotating member 210 may be configured to be rotatable about the second axis Ax2 with respect to the first connecting member 310, and the second rotating member 220 may be configured to be rotatable about the fourth axis Ax4 with respect to the second connecting member 320.

The configurations of the rotating member 200, the connecting member 300, the arm member 400, and/or the wing plate 500 included in the hinge module 180 are described in more detail with reference to FIG. 6.

FIG. 6 is an exploded perspective view illustrating a hinge module according to an embodiment of the disclosure. FIG. 7 is a perspective view illustrating a hinge module according to an embodiment of the disclosure. FIG. 7 may illustrate that components constituting the hinge module other than the wing plate are coupled to each other in the hinge module illustrated in FIG. 6.

Referring to FIGS. 6 and 7 together, the hinge module 180 may further include other components such as a gear member 350, a gear bracket 360, leaf springs 418 and 428, a shaft bracket 390, elastic members 441 and 451, fastening members 442 and 452, and supporting rings 443 and 453, in addition to the rotating member 200, the connecting member 300, the arm member 400, and/or the wing plate 500 described above with reference to the embodiments of FIGS. 4 and 5. However, it should be noted that the disclosure is not necessarily limited thereto, and some of the elements may be omitted according to an embodiment.

The hinge module 180 according to an embodiment of the disclosure may have the plurality of components for driving provided in pair to be disposed to be symmetrical horizontally (or vertically) with respect to a virtual line passing through the center of the electronic device in the width direction. For example, the first rotating member 210 and the second rotating member 220, which are components for driving the hinge module 180, may be substantially the same components and may be provided symmetrically left/right on one side and the other side with respect to a virtual line passing through the center of the center bar 181. The description of the first rotating member 210 may be applied to the second rotating member 220, which is a line symmetric component. The description of the components symmetrically disposed left/right with respect to the center bar 181 may be similarly applied to the description of other components (e.g., the first connecting member 310, the second connecting member 320, the first arm member 410, and the second arm member 420) included in the hinge module 180. Hereinafter, in the description of left/right symmetrically provided components, the description of one component may be applied to the description of the other component symmetrical thereto, although not otherwise mentioned. For example, the description of the first rotating member 210 may be applied to the second rotating member 220. Further, the description of the first connecting member 310 may be applied to the second connecting member 320. Further, the description of the first arm member 410 may be applied to the second arm member 420. Further, the description of the first wing plate 510 may be applied to the second wing plate 520.

According to an embodiment, the first rotating member 210 may be coupled to the rotating bracket 230 on one side, and may be coupled to the first connecting member 310 on the other side. The first rotating member 210 may include a first rail 211 and a second rail 212. According to an embodiment, the first rotating member 210 may be rotatably coupled to the rotating bracket 230 using the first rail 211, and may be independently rotatably coupled to the first connecting member 310 using the second rail 212. According to an embodiment, the first rotating member 210 may rotate about the first axis ax1 as the first rail 211 is inserted into the 1-1th opening 233 and the 1-2th opening 234 formed in the rotating bracket 230 and the first rotating guide hole defined between the 1-1th opening 233 and the 1-2th opening 234. The first rotating member 210 and the second rotating member 220 may be disposed symmetrically with respect to the rotating bracket 230. According to an embodiment, the first rotating member 210 may be disposed so that the second rail 212 is engaged with the first guide rail 312 formed on the first connecting member 310 to rotate about the second axis Ax2. The first guide rail 312 formed on the first connecting member 310 may correspond to a rotating guide rail that allows the first rotating member 210 to rotate about the second axis Ax2 along the first guide rail 312.

According to an embodiment, the second rotating member 220 may be coupled to the rotating bracket 230 on one side, and may be coupled to the second connecting member 320 on the other side. The second rotating member 220 may include a sixth rail 221 and a seventh rail 222. According to an embodiment, the second rotating member 220 may be rotatably coupled to the rotating bracket 230 using the sixth rail 221, and may be independently rotatably coupled to the second connecting member 320 using the seventh rail 222. According to an embodiment, the second rotating member 220 may rotate about the third axis Ax3 as the sixth rail 221 is inserted into the 2-1th opening 235 and the 2-2th opening 236 formed in the rotating bracket 230 and the second rotating guide hole defined between the 2-1th opening 235 and the 2-2th opening 236. According to an embodiment, the first end 221a and the second end 221b of the sixth rail 221 may be parallel to each other. According to an embodiment, the second rotating member 220 may be disposed so that the seventh rail 222 is engaged with the third guide rail 322 formed on the second connecting member 320 to rotate about the fourth axis Ax4. The third guide rail 322 formed on the second connecting member 320 may correspond to a rotating guide rail that allows the second rotating member 220 to rotate about the fourth axis Ax4 along the third guide rail 322.

The hinge module 180 may include a gear member 350 including a first gear 353, a second gear 354, and/or an interlocking gear 355. The interlocking gear 355 may include idle gears 356 and 357 for interlocking the rotation of the first housing 110 with the rotation of the second housing 120. The first gear 353 may include a first shaft 351 capable of rotating about a first interlocking shaft Rx1 parallel to the first shaft Ax1, and a toothed portion provided to engage with the toothed portion of the interlocking gear 355 on one side of the first shaft 351. As another example, the second gear 354 may include a second shaft 352 capable of rotating about a second interlocking shaft Rx2 parallel to the second axis Ax2 and a toothed portion provided to engage with the toothed portion of the interlocking gear 355 on one side of the second shaft 352. A space in which an end of the gear member 350 is seated may be provided on one side of the rotating bracket 230, and the first gear 353 and the second gear 354 of the gear member 350 may rotate about the first interlocking shaft Rx1 and the second interlocking shaft Rx2 while being seated on the rotating bracket 230. According to an embodiment, the gear bracket 360 may be coupled between the gear member 350 and the arm member 400 to prevent or reduce damage caused by friction caused by the movement of the gear member 350 and the movement of the arm member 400.

One side of the first arm member 410 may be connected to the first shaft 351, and the other side of the first arm member 410 may be connected to the first connecting member 310. According to an embodiment, the first arm member 410 may be disposed so that the first shaft 351 is fitted into the through hole formed in the first cam portion 411, and the second guide rail 313 formed in the first connecting member 310 is engaged with the first arm rail 412 formed on the side surface thereof. In the first arm member 410, the first cam portion 411 may be rotatably connected to the first shaft 351 on the first interlocking shaft Rx1, and the first arm rail 412 may be connected to enable linear movement on the second guide rail 313 formed in the first connecting member 310. The second arm member 420 may be disposed so that the second shaft 352 is fitted into the through hole formed in the second cam portion 421, and the fourth guide rail 323 formed in the second connecting member 320 is engaged with the second arm rail 422 formed on the side surface thereof. In the second arm member 420, the second cam portion 421 may be connected to the second shaft 352 on the second interlocking shaft Rx2, and the second arm rail 422 may be connected to enable linear movement on the fourth guide rail 323 formed in the second connecting member 320. According to an embodiment, the first leaf spring 418 and the second leaf spring 428 may be disposed on the lower surfaces of the first arm member 410 and the second arm member 420, respectively, to assist the movement of the first arm member 410 and the second arm member 420.

The hinge module 180 may include two types of cam structures. Here, one of the two types of cam structures may correspond to a cam included in the arm member 400, and the other may correspond to a cam included in the cam member 430. The cam included in the arm member 400 may be a cam that moves based on an angle between the first housing (e.g., the first housing 110 of FIG. 1) and the second housing (e.g., the second housing 120 of FIG. 1) of the electronic device (e.g., the electronic device 100 of FIG. 1), and the cam included in the cam member 430 may be a fixed cam that may move on the cam axis by the elastic members 441 and 451 disposed on the cam axis but does not rotate with respect to the cam axis. In the arm member 400, e.g., in the first cam portion 411 of the first arm member 410 and the second cam portion 421 of the second arm member 420, a cam may be formed at a portion facing the center of the electronic device 100, and in the cam member 430, a first counter cam 431 and a second counter cam 432 may be formed at positions corresponding to the first cam portion 411 of the first arm member 410 and the second cam portion 421 of the second arm member 420, respectively. The cams included in the arm member 400 and the cam member 430 may be engaged with each other by having a valley portion and a mounting portion, respectively. For example, all of the cams included in the arm member 400 and the cam member 430 may have the valley portions and the mounting portions alternately arranged along the circumference. According to an embodiment, the cams included in the arm member 400 and the cam member 430 may include an inclined portion between the valley portion and the mounting portion, respectively. According to an embodiment, in a state in which the cams included in the arm member 400 and the cam member 430 are engaged with each other, the relative positions of the cams included in the arm member 400 and the cam member 430 may not change even if the spring force is transferred in the cam axis direction unless a separate external force is applied by the frictional force acting on the cam. However, when an external force larger than or equal to a predetermined magnitude is applied, the cams included in the arm member 400 may move in a centrifugal direction perpendicular to the cam axis. Accordingly, the relative positions of the cams included in the arm member 400 and the cam member 430 may be changed. According to an embodiment, the cams included in the arm member 400 and the cam member 430 may implement a free stop function (e.g., flex mode) of the electronic device to maintain a firmly folded state while the elastic members 441 and 451 continuously exert a force to push the cam in the folded state of the electronic device, maintain a partially unfolded state by themselves within a specific angular range in the intermediate state between the folded state and the unfolded state, and maintain a firmly unfolded state through a force to continuously push the cam by the elastic members 441 and 451 in the unfolded state.

The first arm member 410 and the second arm member 420 may be inserted into the first shaft 351 and the second shaft 352, respectively, and the first arm member 410 and the second arm member 420 may move clockwise (or counterclockwise) and counterclockwise (or clockwise) about the first shaft 351 and the second shaft 352, respectively, when viewed in the width direction of the electronic device. According to an embodiment, the rotating bracket 230 may be coupled to one side end of the first shaft 351 and the second shaft 352, and the shaft bracket 390 for supporting the first shaft 351 and the second shaft 352 may be coupled to the other side end thereof. The gear bracket 360 may be disposed between one side end and the other side end of the first shaft 351 and the second shaft 352. According to an embodiment, the arm member 400 and the cam member 430 may be disposed between the gear bracket 360 and the shaft bracket 390. Further, the elastic members 441 and 451 for applying a spring force to the cams provided in the arm member 400 and the cam member 430 may be disposed between the gear bracket 360 and the shaft bracket 390. For example, the elastic members 441 and 451 may include a first elastic member 441 and a second elastic member 451. For example, the elastic members 441 and 451 may be torsional springs. Further, at least one fastening member (e.g., washer) 442 and 452 and at least one supporting ring (e.g., snap ring or e ring) 443 and 453 may be disposed between the elastic members 441 and 451 and the shaft bracket 390. According to an embodiment, the at least one fastening member 442 or 452 may include a first fastening member 442 and a second fastening member 452 inserted into the first shaft 351 and the second shaft 352 and fastened to the first elastic member 441 and the second elastic member 451, respectively. According to an embodiment, the at least one supporting ring 443 and 453 may include a first supporting ring 443 inserted into the first shaft 351 and supporting the first elastic member 441, and may include a second supporting ring 453 inserted into the second shaft 352 and supporting the second elastic member 451.

The wing plate 500 may include a first wing plate 510 positioned on a side of the first housing 110 and a second wing plate 520 positioned on a side of the second housing 120 with respect to a folding axis (e.g., the folding axis A of FIG. 1). The first wing plate 510 and the second wing plate 520 may be disposed symmetrically up/down with respect to a folding axis (e.g., the folding axis A of FIG. 1). The first wing plate 510 may include a first surface 511 facing in a second direction (+Z-axis direction) and a second surface 512 facing in a first direction (-Z-axis direction). According to an embodiment, the first surface 511 of the first wing plate 510 may be formed as a flat surface to support the display 130, and the second surface 512 may include a plurality of protrusions 514, 515, and 516 for coupling with other components. In this case, the first wing plate 510 may be coupled to the first rotating member 210 using some (e.g., the first protrusion 514) of the plurality of protrusions 514, 515, and 516, and may be coupled to the first connecting member 310 using others (e.g., the second protrusion 515 and the third protrusion 516) of the plurality of protrusions 514, 515, and 516. Correspondingly, the first rotating member 210 may include a first seating surface 213 on which the second surface 512 of the first wing plate 510 is disposed, and a third rail 214 to which the first protrusion 514 is coupled may be formed on the first seating surface 213. A fourth rail 315 and/or a fifth rail 316 to which the second protrusion 515 and/or the third protrusion 516 of the first wing plate 510 are coupled may be formed on the first connecting member 310. According to various embodiments, when there are two or more protrusions (e.g., the second protrusion 515 and the third protrusion 516) that play the same role among the plurality of protrusions 514, 515, and 516, any one of the protrusions may be omitted, or other protrusion components not illustrated in the drawings may be additionally disposed. The second wing plate 520 may include a third surface 521 facing in the second direction (+Z-axis direction) and a fourth surface 522 facing in the first direction (-Z-axis direction). According to an embodiment, the third surface 521 of the second wing plate 520 may be formed as a flat surface to support the display 130, and the fourth surface 522 may include a plurality of protrusions 524, 525, and 526 for coupling with other components. At this time, the second wing plate 520 may be coupled to the second rotating member 220 using some (e.g., the fourth protrusion 524) of the plurality of protrusions 524, 525, and 526, and may be coupled to the second connecting member 320 using others (e.g., the fifth protrusion 525 and the sixth protrusion 526) of the plurality of protrusions 524, 525, and 526. Correspondingly, the second rotating member 220 may include a second seating surface 223 on which the fourth surface 522 of the second wing plate 520 is disposed, and an eighth rail 224 to which the fourth protrusion 524 is coupled may be formed on the second seating surface 223. The ninth rail 325 and/or the tenth rail 326 to which the fifth protrusion 525 and/or the sixth protrusion 526 of the second wing plate 520 is coupled may be formed on the second connecting member 320. According to various embodiments, when there are two or more protrusions (e.g., the fifth protrusion 525 and the sixth protrusion 526) that play the same role among the plurality of protrusions 524, 525, and 526, any one of the protrusions may be omitted, or other protrusion components not illustrated in the drawings may be additionally disposed.

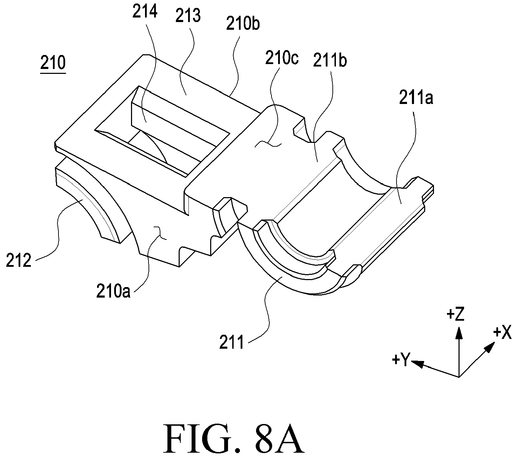

Hereinafter, components included in the hinge module 180 are described in more detail with reference to the embodiment of FIG. 8A.

In the description of the embodiments of the disclosure, sub components of substantially the same two components may be described without distinguishing between 'first' and 'second'. Hereinafter, in describing sub components of substantially the same two components, e.g., a description of sub components included in a 'first component' may be equally applied to a description of sub components included in a 'second component'. Accordingly, the description of the sub components included in the 'second component' may be omitted within a range overlapping the description of the sub components included in the 'first component', and the description of the sub components included in the 'first component' may be applied to the description of the sub components included in the 'second component'. For example, as described above with reference to the embodiments of FIGS. 6 and 7, the first rotating member 210 and the second rotating member 220 may have substantially the same structure, and their technical features may also be the same. Accordingly, the description of the first rotating member 210 may be applied to the second rotating member 220. Further, the first connecting member 310 and the second connecting member 320, the first arm member 410 and the second arm member 420, and the first wing plate 510 and the second wing plate 520 may have substantially the same structure, respectively. For example, the description of the first connecting member 310, the first arm member 410, and the first wing plate 510 may apply mutatis mutandis to the second connecting member 320, the second arm member 420, and the second wing plate 520, respectively.

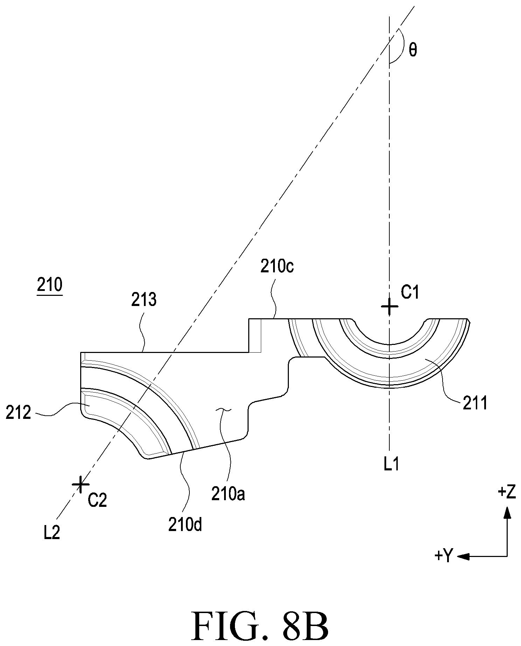

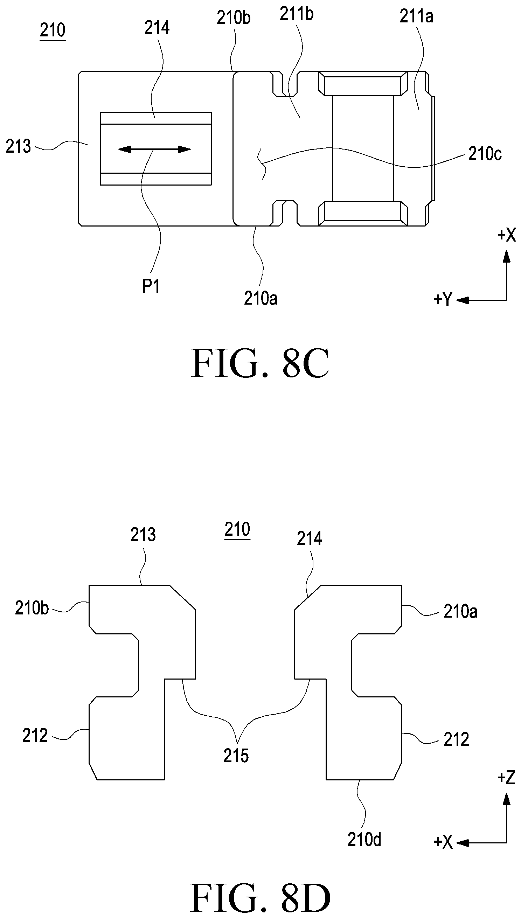

FIG. 8A is a perspective view illustrating a rotating member according to an embodiment of the disclosure. FIG. 8B is a front view illustrating a rotating member according to an embodiment of the disclosure. FIG. 8C is a view illustrating a rotating member viewed from thereabove, according to an embodiment of the disclosure. FIG. 8D is a view illustrating a surface where a wing plate is mounted and a cross section of a third rail in a rotating member according to an embodiment of the disclosure.

Referring to FIGS. 8A to 8D, a rotating member (e.g., the first rotating member 210) may include two rotary elements (e.g., the first rail 211 and the second rail 212) configured to be rotatable about different axes. For example, when a surface of the first rotating member 210 facing in the second direction (+Z-axis direction) is referred to as an upper surface 210c, the first rotating member 210 may include a first rail 211 and a second rail 212 formed on the first side surface 210a facing in the width direction (X-axis direction) of the electronic device. According to an embodiment, the first rail 211 and the second rail 212 may also be formed on the second side surface 210b facing in the width direction of the electronic device. The first rail 211 and the second rail 212 disposed on the first side surface 210a may be formed symmetrically with respect to a virtual line passing through the centers of the first rail 211, the second rail 212, and the first rotating member 210 disposed on the second side surface 210b in the length direction. According to an embodiment, in the hinge module 180, the first rail 211 may be disposed closer to a folding axis (e.g., the folding axis A of FIG. 1) than the second rail 212. According to an embodiment, the first rail 211 may have a convex shape in the first direction (-Z-axis direction), and the second rail 212 may have a convex shape in the second direction (+Z-axis direction). According to an embodiment, the first rail 211 may be configured in an arc shape when viewed in the width direction (X-axis direction) of the electronic device. According to an embodiment, the first end 211a and the second end 211b of the first rail 211 may be parallel to each other. The first rail 211 may move along the 1-1th opening 233 and the 1-2th opening 234 of the rotating bracket 230 illustrated in FIG. 6, and the first rotating guide hole defined between the 1-1th opening 233 and the 1-2th opening 234, and may rotate about the first axis (e.g., the first axis Ax1 of FIG. 5). According to an embodiment, the second rail 212 may also be configured in an arc shape when viewed in the width direction (X-axis direction) of the electronic device. The second rail 212 may move in engagement with the first guide rail 312 of the first connecting member 310 illustrated in FIG. 6 and may rotate about a second axis (e.g., the second axis Ax2 of FIG. 5). According to an embodiment, the first axis Ax1 and the second axis Ax2, which are rotation centers of the first rail 211 and the second rail 212, may be formed at positions spaced apart from each other by a predetermined distance, and may not be formed on the same plane (e.g., the XY plane). Correspondingly, the first rail 211 and the second rail 212 of the first rotating member 210 may not be formed on the same plane (e.g., XY plane). For example, the first rail 211 may be formed adjacent to the upper surface 210c of the first rotating member 210, and the second rail 212 may be formed adjacent to the lower surface 210d of the first rotating member 210. In the foldable operation of the electronic device, the relative position of the first axis Ax1 of the first rotating member 210 may be fixed without being changed, and the position of the second axis Ax2 may be dependently changed by rotation of the first axis Ax1. According to an embodiment, when the electronic device is in the unfolded state, the second axis Ax2 of the first rotating member 210 may be formed at a position lower than the first axis Ax1, and when the electronic device is in the folded state, the second axis Ax2 of the first rotating member 210 may be formed at a position higher than the first axis Ax1. According to an embodiment, the first rotating member 210 may include a first seating surface 213 that is a surface facing the first wing plate 510. According to an embodiment, the first seating surface 213 may be parallel to the upper surface 210c facing in the second direction (+Z-axis direction) and may be formed to have a predetermined step from the upper surface 210c. At least a portion of the first wing plate 510 may be seated on the first seating surface 213. According to an embodiment, a separate third rail 214 different from the first rail 211 and the second rail 212 may be formed on the first seating surface 213. The first rail 211 and the second rail 212 may be configured so that the first rotating member 210 rotates about a first axis (e.g., the first axis Ax1 of FIG. 5) and a second axis (e.g., the second axis Ax2 of FIG. 5), respectively. Meanwhile, the third rail 214 may be configured to allow the first wing plate 510 to linearly slide along one direction (e.g., a direction perpendicular to the width direction (X-axis direction) of the electronic device). Referring to FIGS. 8C and 8D, the third rail 214 is a component in the form of an opening or a through hole, and may be configured so that a first protrusion (e.g., the first protrusion 514 of FIG. 6) disposed on a lower surface of the first wing plate 510 is inserted and fastened thereto to move along the third rail 214. For example, a stepped portion 215 may be formed on the third rail 214 to allow the first protruding portion 514 disposed on the lower surface of the first wing plate 510 to be fastened in a hook manner. The first wing plate 510 may slide along the first path P1 parallel to the length direction of the third rail 214 in a state in which the first protrusion 514 is fastened to the third rail 214 and is seated on the first seating surface 213.

According to an embodiment, the first rail 211 and the second rail 212 may face in different directions. For example, the first rail 211 and the second rail 212 may face in opposite directions. The direction of each of the first rail 211 and the second rail 212 may be determined depending on the length of the arc (or the angle of the arc corresponding to the length of the arc) and/or the position of the arc. In this case, the direction of the first rail 211 may be expressed with respect to the direction of the virtual line L1 connecting the center C1 of the arc of the first rail 211 to the center of the arc length, and the direction of the second rail 212 may be described with respect to the direction of the virtual line L2 connecting the center C2 of the arc of the second rail 212 to the center of the arc length.

Referring to FIG. 8B, the first rail 211 may be concave in the second direction (+Z-axis direction) (or convex in the first direction (-Z-axis direction)), and the second rail 212 may be convex in the second direction (+Z-axis direction). As another example, the first rail 211 may be expressed as convex downward, and the second rail 212 may be expressed as convex upward. As another example, the first rail 211 and the second rail 212 may be expressed as convex in opposite directions. Here, 'convex in the opposite directions' may mean that the direction of the first rail 211 and the substantial direction of the second rail 212 face in opposite directions. That the first rail 211 and the second rail 212 are convex in opposite directions does not necessarily mean that the first rail 211 and the second rail 212 have an angular difference of 180 degrees. According to an embodiment, the angle θ between the virtual line L1 connecting the center C1 of the arc of the first rail 211 to the center of the arc length and the virtual line L2 connecting the center C2 of the arc of the second rail 212 to the center of the arc length may be formed, e.g., within 120 degrees to 240 degrees. For example, in FIG. 8B, the angle θ between the virtual line L1 connecting the center C1 of the arc of the first rail 211 to the center of the arc length and the virtual line L2 connecting the center C2 of the arc of the second rail 212 to the center of the arc length may be 135 degrees. However, the angular difference may vary according to embodiments.

The above description of the first rail 211, the second rail 212, the first seating surface 213, and the third rail 214 of the first rotating member 210 may be applied to the description of the sixth rail 221, the seventh rail 222, the second seating surface 223, and the eighth rail 224 of the second rotating member 220.

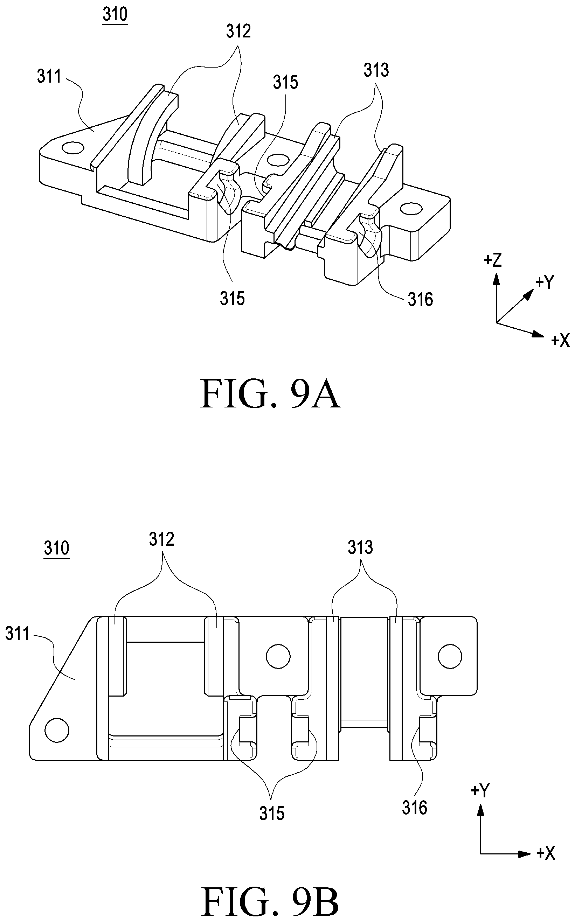

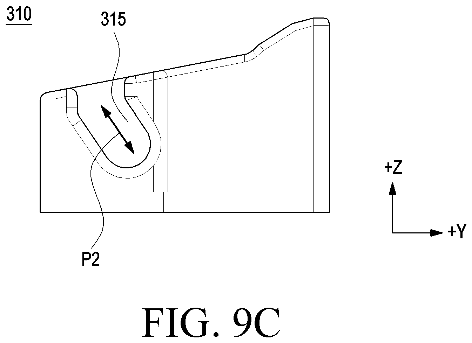

FIG. 9A is a perspective view illustrating a connecting member according to an embodiment of the disclosure. FIG. 9B is a view illustrating a connecting member viewed from thereabove, according to an embodiment of the disclosure. FIG. 9C is a view illustrating a fourth rail of a connecting member according to an embodiment of the disclosure.

Referring to FIGS. 9A to 9C, the connecting member (e.g., the first connecting member 310) may include a body portion (e.g., the first body portion 311) and two guide rails (e.g., the first guide rail 312 and the second guide rail 313) formed to be spaced apart from each other by a predetermined distance along the length direction of the body portion 311. According to an embodiment, the first connecting member 310 may be fixedly coupled to a supporting member (e.g., the first supporting member 112 of FIG. 3) on the lower surface of the first body portion 311, and may be fastened to each of the first rotating member 210 and the first arm member 410 on the upper surface of the first body portion 311. The second rail 212 of the first rotating member 210 may be engaged with the first guide rail 312 of the first connecting member 310, and the first arm rail 412 of the first arm member 410 may be engaged with the second guide rail 313 of the first connecting member 310. According to an embodiment, the first guide rail 312 may correspond to a rotating guide rail that guides the second rail 212 to rotate along an axis (e.g., the second axis Ax2 of FIG. 7). According to an embodiment, the first guide rail 312 may be formed in an arc shape when viewed in the width direction of the electronic device. For example, the first guide rail 312 may be formed in an arc shape corresponding to an angle of about 90 degrees. According to an embodiment, the second guide rail 313 may be formed in an arc shape having a radius of curvature significantly larger than that of the first guide rail 312. Further, in contrast to the first guide rail 312 guiding the second rail 212 along an axis (e.g., the second axis Ax2), the second guide rail 313 may guide the arm rail 412 substantially in a straight line. According to an embodiment, in the first connecting member 310, a pair of first guide rails 312 and a pair of second guide rails 313 may be provided corresponding to the first rail 211 and the second rail 212 formed on two opposite side surfaces of the first rotating member 210. A first wing plate 510 may be disposed above the first connecting member 310. At least a portion of the first connecting member 310 may face the second surface 512 facing in the first direction (-Z axis direction) of the first wing plate 510. According to an embodiment, at least one rail may be formed on the first connecting member 310. For example, a fourth rail 315 may be formed on the first connecting member 310. Further, the fifth rail 316 may be additionally or alternatively formed on the first connecting member 310 with respect to the fourth rail 315. The fourth rail 315 and/or the fifth rail 316 may be formed in a recess shape for receiving at least a portion of another component (e.g., the second protrusion 515 and/or the third protrusion 516). The fourth rail 315 may be configured so that at least one second protrusion 515 disposed on the lower surface of the first wing plate 510 is inserted and fastened thereto to move along the fourth rail 315. In the drawings included in the disclosure, it is illustrated that two configurations of at least one rail included in the first connecting member 310 and at least one protrusion formed on the first wing plate 510 corresponding thereto are formed. However, the disclosure is not necessarily limited thereto, and it should be noted that According to an embodiment, one rail and one protrusion may be formed on the first connecting member 310 and the first wing plate 510, or three or more rails and three or more protrusions may be included. According to the embodiment illustrated in FIG. 6 together with FIGS. 9A to 9C, two protrusions (e.g., the second protrusion 515 and the third protrusion 516) protruding by a predetermined length in the width direction (X-axis direction) of the electronic device may be disposed on the lower surface of the first wing plate 510, and two rails (e.g., the fourth rail 315 and the fifth rail 316) having a predetermined depth in the width direction (X-axis direction) of the electronic device may be formed on the first connecting member 310. Referring to FIG. 9C, in a state in which the second protrusion 515 and the third protrusion 516 are respectively fastened to the fourth rail 315 and the fifth rail 316, the second protrusion 515 and the third protrusion 516 of the first wing plate 510 may slide along a second path P2 parallel to the length directions of the fourth rail 315 and the fifth rail 316. According to an embodiment, the fourth rail 315 and the fifth rail 316 may be formed to be inclined by a predetermined angle with respect to the second direction (+Z-axis direction) in the unfolded state of the electronic device. As the fourth rail 315 and the fifth rail 316 are formed to be inclined as illustrated in FIG. 9C, e.g., when the electronic device is changed from the unfolded state to the folded state, the second protrusion 515 and the third protrusion 516 may be moved away from the center of the hinge module 180, but may be further close to the supporting member (e.g., the supporting member 112 of FIG. 3) supporting the first connecting member 310 and/or the first connecting member 310. The description of the first body portion 311, the first guide rail 312, the second guide rail 313, the fourth rail 315, and the fifth rail 316 of the first connecting member 310 may be applied to the description of the second body 321, the third guide rail 322, the fourth guide rail 323, the ninth rail 325, and the tenth rail 326 of the second connecting member 320.

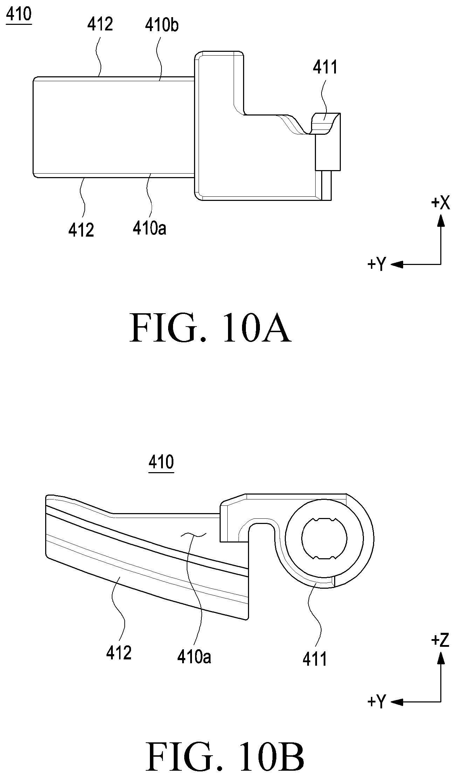

FIG. 10A is a view illustrating an arm member viewed from thereabove, according to an embodiment of the disclosure. FIG. 10B is a front view illustrating an arm member according to an embodiment of the disclosure.

Referring to FIGS. 10A and 10B, an arm member (e.g., the first arm member 410) may include a through hole into which a shaft (e.g., the first shaft 351) is fitted, and may include a cam portion (e.g., the first cam portion 411) engaged with the cam member 430. Further, the arm member (e.g., the first arm member 410) may include a rail (e.g., the first arm rail 412) configured to rotate in conjunction with rotation of the rotating member (e.g., the first rotating member 210). For example, the first arm member 410 may include a first arm rail 412 formed on the first side surface 410a facing in the width direction (X-axis direction) of the electronic device. According to an embodiment, the first arm member 410 may also have the first arm rail 412 formed on the second side surface 410b facing in the width direction (X-axis direction) of the electronic device. The first arm rail 412 may be formed so that at least a partial section thereof has a predetermined curvature when viewed in the width direction (X-axis direction) of the electronic device. Further, the first arm rail 412 may be formed to be inclined at a predetermined angle with respect to the second direction (+Z-axis direction) in a state in which the electronic device is unfolded. When the first arm member 410 moves in response to rotation on the axis (e.g., the first axis Ax1) of the first rotating member 210, the first cam portion 411 and the first arm rail 412 of the first arm member 410 may rotate about an interlocking axis (e.g., the first interlocking axis Rx1) parallel to the axis Ax1. For example, when the electronic device is changed from the unfolded state to the folded state, the first arm rail 412 of the first arm member 410 may be disengaged from, or partially engaged with the second guide rail 313 of the first connecting member 310 in a state in which the first arm rail 412 is completely engaged with the second guide rail 313. The description of the first cam portion 411 and the first arm rail 412 of the first arm member 410 may be applied to the description of the second cam portion 421 and the second arm rail 422 of the second arm member 420.

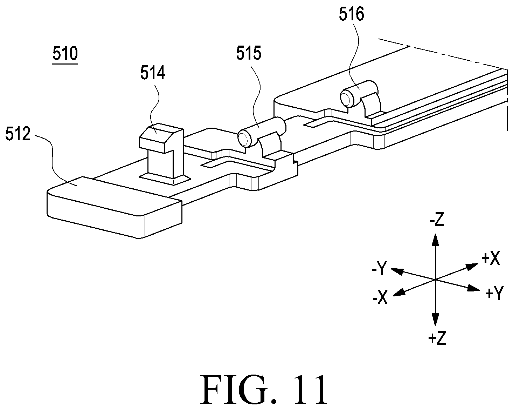

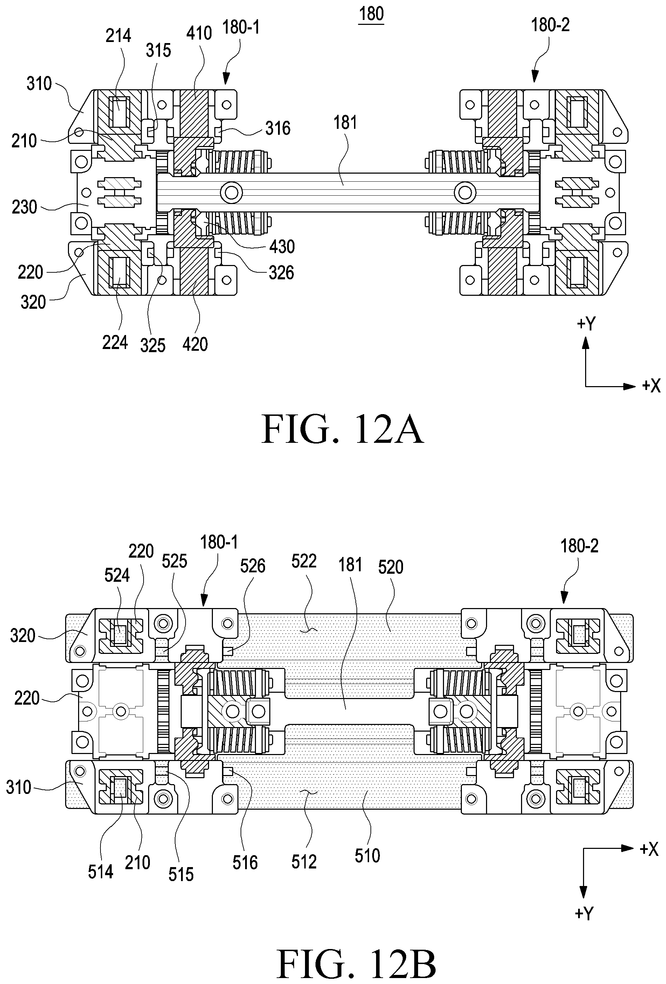

FIG. 11 is a perspective view illustrating a wing plate according to an embodiment of the disclosure. FIG. 12A is a view illustrating a hinge module except for a wing plate according to an embodiment of the disclosure. FIG. 12B is a view illustrating a hinge module including a wing plate according to an embodiment of the disclosure.

FIG. 12A may illustrate a hinge module from which a wing plate is excluded when an electronic device is in the unfolded state, as viewed from above, and FIG. 12B may illustrate a hinge module including a wing plate when an electronic device is in the unfolded state, as viewed from below.

FIG. 11 illustrates that a surface (e.g., the second surface 512) of a wing plate (e.g., the first wing plate 510) facing in a first direction (-Z-axis direction) faces upward. Referring to FIG. 11, the first surface 511 of the first wing plate 510 may be flat, and a plurality of protrusions 514, 515, and 516 may be formed on the second surface 512. One of the plurality of protrusions 514, 515, and 516 may be a first protrusion 514, which may be formed to be inserted into the third rail 214 formed in the first rotating member 210 and to be slidable along the third rail 214. For example, the first protrusion 514 may protrude by a predetermined height in the first direction (-Z-axis direction), and its end portion may be a hook-shaped protrusion formed to be fixed to a stepped portion (e.g., the stepped portion 215 of FIG. 8D) formed on the third rail 214. Further, the second protrusion 515 and the third protrusion 516 among the plurality of protrusions 514, 515, and 516 may be inserted into the fourth rail 315 and the fifth rail 316 formed in the first connecting member 310 and may be formed to be slidable along the fourth rail 315 and the fifth rail 316. For example, the second protrusion 515 and the third protrusion 516 may have a cylindrical shape. Further, the second protrusion 515 and the third protrusion 516 may be disposed so that the bottom surface and/or the top surface of the cylindrical shape faces in a direction parallel to the length direction of the first wing plate 510 (i.e., a direction parallel to the width direction (X-axis direction)) of the electronic device. According to an embodiment, a moving distance of the wing plate 510 may be set by including the second protrusion 515 and the third protrusion 516 movable on the fourth rail 315 and the fifth rail 316. Accordingly, the fourth rail 315 and the fifth rail 316 may be referred to as a "distance determination protrusion rail". According to the embodiment illustrated in FIGS. 12A and 12B, the two rotary elements (e.g., the fourth rail 315 and the fifth rail 316) formed in the connecting member (e.g., the first connecting member 310) may be formed at positions spaced apart from each other in the width direction (X-axis direction) of the electronic device on the connecting member (e.g., the first connecting member 310). According to an embodiment, the fifth rail 316 may be provided as a single-type rail at an edge of the first connecting member 310 as indicated by reference numeral 316, and the fourth rail 315 may be provided as a dual-type rail at an intermediate position of the first connecting member 310 as indicated by reference numeral 315. In the embodiment illustrated in FIG. 11, it is illustrated that a third protrusion 516 is formed that has one side supported from the wing plate and the other side having a free end, corresponding to the single-type rail (fifth rail 316), and a second protrusion 515 is formed that have one side and the other side each having a free end, corresponding to the dual-type rail (fourth rail 315). However, the disclosure is not necessarily limited thereto, and as illustrated in FIG. 12B, protrusions having free ends on one side and the other side may be formed for both the single type rail and the dual type rail. The description of the first protrusion 514, the second protrusion 515, and the third protrusion 516 of the first wing plate 510 may be applied to the description of the fourth protrusion 524, the fifth protrusion 525, and the sixth protrusion 526 of the second wing plate 520.

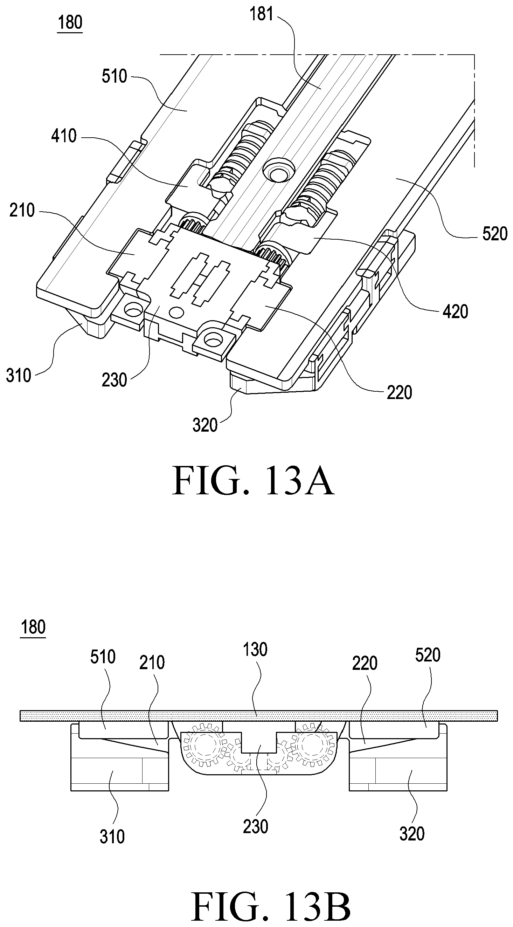

Hereinafter, the operating principle of the hinge module according to the disclosure is described in detail with reference to FIG. 13A and the subsequent figures.

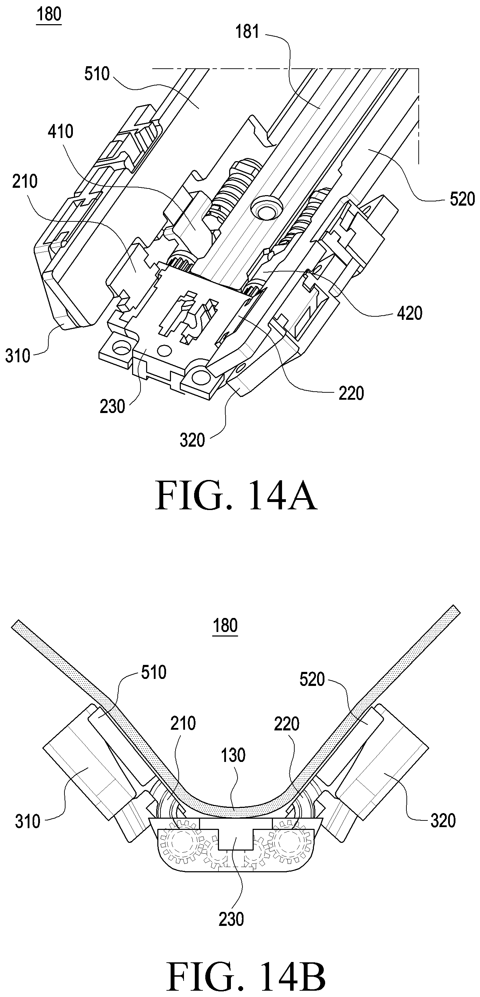

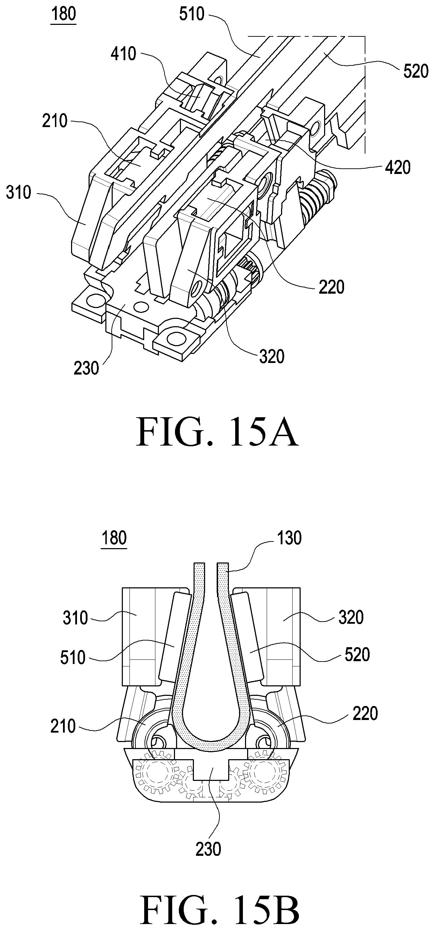

FIG. 13A is a perspective view illustrating a hinge module in an unfolded state of an electronic device according to an embodiment of the disclosure. FIG. 13B is a cross-sectional view illustrating a hinge module in an unfolded state of an electronic device according to an embodiment of the disclosure. FIG. 14A is a perspective view illustrating a hinge module in an intermediate state of an electronic device according to an embodiment of the disclosure. FIG. 14B is a cross-sectional view illustrating a hinge module in an intermediate state of an electronic device according to an embodiment of the disclosure. FIG. 15A is a perspective view illustrating a hinge module in a folded state of an electronic device according to an embodiment of the disclosure. FIG. 15B is a cross-sectional view illustrating a hinge module in a folded state of an electronic device according to an embodiment of the disclosure.

FIGS. 13B, 14B, and 15B may illustrate a hinge module as viewed in a width direction (X-axis direction) of an electronic device. Further, FIGS. 13B, 14B, and 15B may additionally illustrate a state in which the display 130 is disposed on the hinge module 180. As mentioned above, the hinge module 180 may include components symmetrical to each other with respect to a folding axis (e.g., the folding axis A of FIG. 1) or a center bar 181. As illustrated in FIGS. 13A and 13B, when the electronic device is in the unfolded state, the symmetrical components may be spaced apart from each other by an angle of about 180 degrees. As illustrated in FIGS. 14A and 14B, when the electronic device is in an intermediate state between the unfolded state and the folded state, the symmetrical components may be spaced apart from each other by an angle of, e.g., about 90 degrees. In the folded state of the electronic device of FIGS. 15A and 15B, the symmetrical components may face each other or may be widened by, e.g., a negative angle (e.g., -5 degrees). It should be noted that the reference to the angle of 90 degrees in the intermediate state and the angle of -5 degrees in the folded state are merely exemplary and are not necessarily limited thereto. According to an embodiment, when the components included in the hinge module 180 are spaced apart by a negative angle (e.g., -5 degrees) (e.g., a dumbbell-shaped (or water drop-shaped) hinge module) as compared with when the components included in the hinge module 180 are spaced apart in a U-shape and face each other (e.g., a U-shaped hinge module) in the folded state, it may be effective in reducing creases on the display 130 and reducing delamination of the portion where the screens contact each other in the folded state of the electronic device.

According to an embodiment of the disclosure, the hinge module 180 may adopt a dumbbell-shape (or water drop-shape) hinge module capable of reducing creases of the display 130 and delamination between the screen and the screen. As illustrated in FIG. 15B, the dumbbell-shape (or water drop-shape) hinge module according to an embodiment of the disclosure may secure a space for allowing the display 130 to be smoothly folded around a folding axis (e.g., the folding axis A of FIG. 1) in a state in which the electronic device is folded, and may firmly support the display 130 in a state in which the electronic device is unfolded.

According to an embodiment, in the unfolded state of the electronic device, the wing plate (e.g., the first wing plate 510) may support the display 130 in a flat state, e.g., referring to the embodiment illustrated in FIG. 13B. Alternatively, in a state in which the electronic device is folded, e.g., referring to the embodiment illustrated in FIG. 15B, the first wing plate 510 may support the display 130 in a state of being inclined at a predetermined angle with respect to the second direction (+Z-axis direction) of the electronic device. For example, the first wing plate 510 may be configured to switch between a plane support shape and an inclination support shape. The first wing plate 510 may be connected to the first rotating member 210 using the first protrusion 514, and may be configured to be seated on the first seating surface 213 of the first rotating member 210 and to be slidable on the first seating surface 213. Further, the first wing plate 510 may be connected to the first connecting member 310 using the second protrusion 515 and the third protrusion 516, and may be configured so that the second protrusion 515 and the third protrusion 516 are slidable on the fourth rail 315 and the fifth rail 316 of the first connecting member 310. According to an embodiment, referring back to FIGS. 9A to 9C, the first connecting member 310 may be formed so that at least a portion of the first body portion 311 is formed to be inclined with respect to the second direction (+Z-axis direction). For example, in the first body portion 311, partition walls disposed around the first guide rail 312 and the second guide rail 313 may be formed to be inclined with respect to the second direction (+Z-axis direction). Such an inclined structure allows the first wing plate 510 to serve as an inclination support when the electronic device switches from the unfolded state to the folded state.

The description of the first rotating member 210, the first connecting member 310, the first arm member 410, and the first wing plate 510 of FIGS. 13A to 15B may be applied to the description of the second rotating member 220, the second connecting member 320, the second arm member 420, and the second wing plate 520.

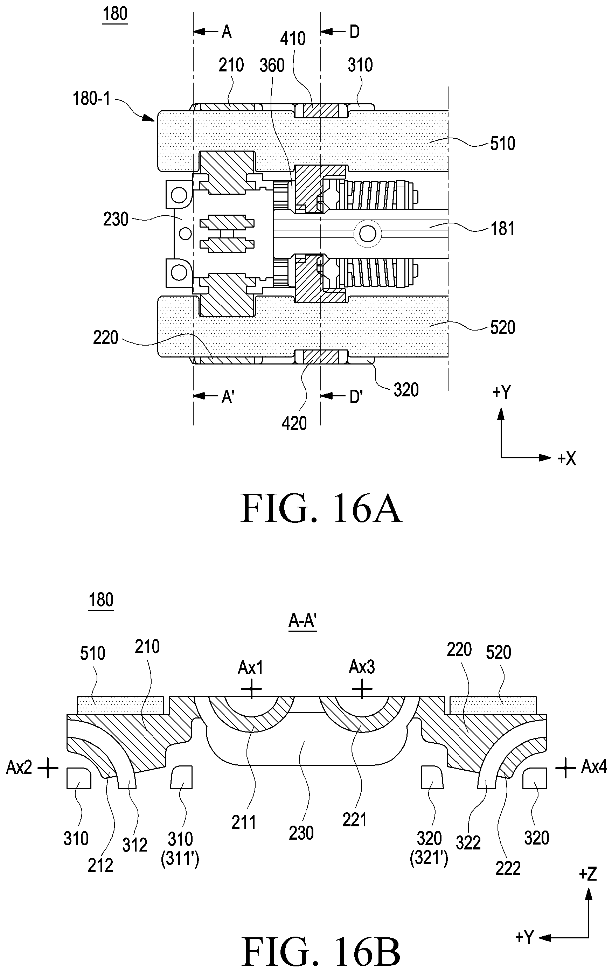

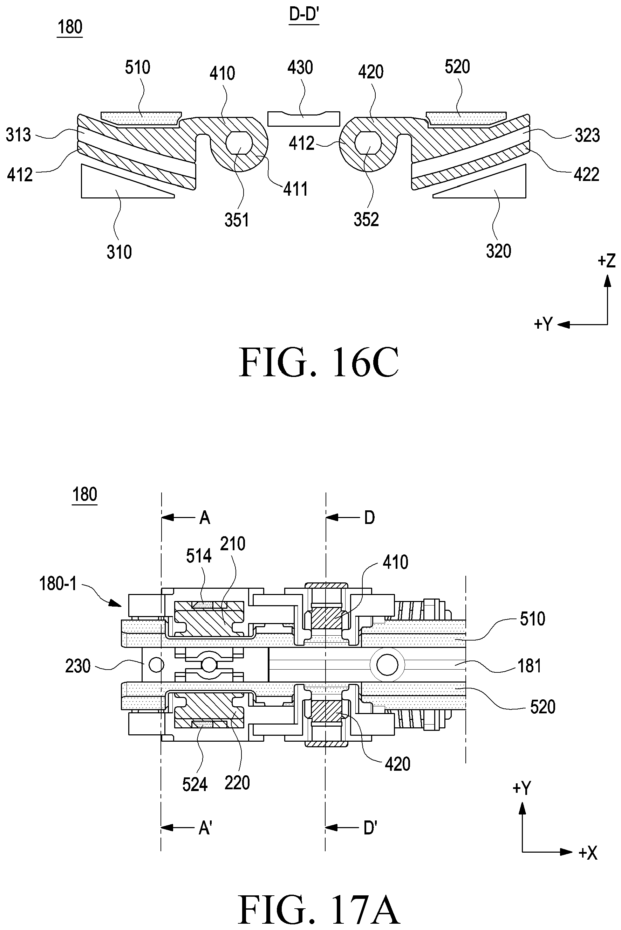

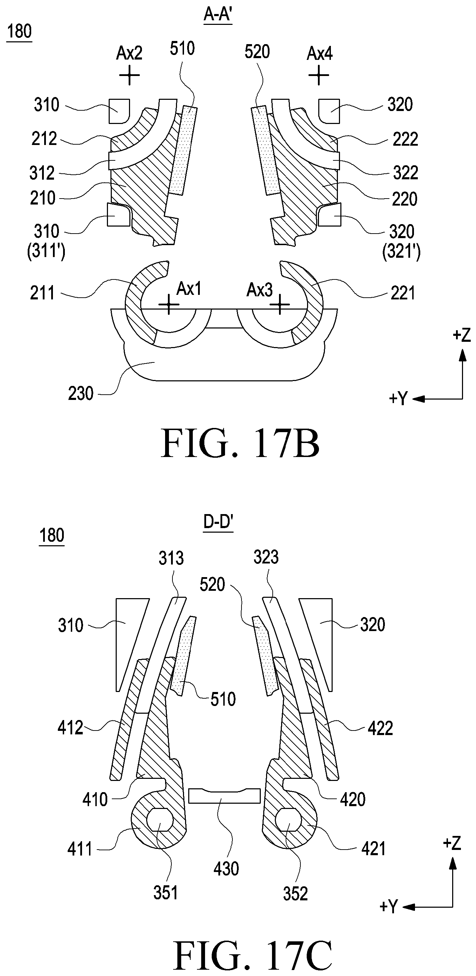

FIG. 16A is a view illustrating a hinge module in an unfolded state of an electronic device according to an embodiment of the disclosure. FIG. 16B may show a cross-section taken along direction A-A' of the hinge module of FIG. 16A according to an embodiment of the disclosure. FIG. 16C may show a cross-section taken along direction D-D' of the hinge module of FIG. 16A according to an embodiment of the disclosure. FIG. 17A is a view illustrating a hinge module in a folded state of an electronic device according to an embodiment of the disclosure. FIG. 17B may show a cross-section taken along direction A-A' of the hinge module of FIG. 17A according to an embodiment of the disclosure. FIG. 17C may show a cross-section taken along direction D-D' of the hinge module of FIG. 17A according to an embodiment of the disclosure.

Referring to FIGS. 16A, 16B, 17A, 17B, and 17C, it is possible to understand the relative positions and motions between the components, e.g., the first rotating member 210, the second rotating member 220, the first connecting member 310, the second connecting member 320, the first arm member 410, and the second arm member 420, while the electronic device switches from the unfolded state to the folded state (or from the folded state to the unfolded state).

Referring to FIGS. 16A, 16B, 17A, and 17B, the first rotating member 210 and the second rotating member 220 included in the hinge module 180 may rotate about the first axis Ax1 and the third axis Ax3, respectively, with respect to the rotating bracket 230. In the process of switching from the unfolded state to the folded state (or vice versa), the first rotating member 210 and the second rotating member 220 may rotate about the second axis Ax2 and the fourth axis Ax4 with respect to the first connecting member 310 and the second connecting member 320, respectively. According to an embodiment, the first axis Ax1 and the third axis Ax3, which are the centers of rotation of the first rotating member 210 and the second rotating member 220, may be formed in the space around the hinge module 180, and the second axis Ax2 and the fourth axis Ax4 may also be formed in the space around the hinge module 180. According to an embodiment, the first rotating member 210 and the second rotating member 220 may be supported by the first connecting member 310 and the second connecting member 320 while rotating on rotating bracket 230, and the operating range may be partially limited. Further, According to an embodiment, when the electronic device is in the folded state, one side of each of the first rotating member 210 and the second rotating member 220 may be supported by the supports 311' and 321' of the body portions included in the first connecting member 310 and the second connecting member 320.

Referring to FIGS. 16A, 16C, 17A, and 17C, the first arm member 410 and the second arm member 420 included in the hinge module 180 may rotate about the shafts 351 and 352, respectively. While the electronic device switches from the unfolded state to the folded state, the first arm member 410 and the second arm member 420 may slide with respect to the first connecting member 310 and the second connecting member 320, respectively, and as they are folded at a narrow angle, the area in which their respective rails are engaged with each other may be reduced. While the electronic device switches from the folded state to the unfolded state, the first arm member 410 and the second arm member 420 may slide with respect to the first connecting member 310 and the second connecting member 320, respectively, and the area in which their respective rails are engaged with each other may increase. For example, the area in which the first arm rail 412 and the second arm rail 422 are engaged with the second guide rail 313 and the fourth guide rail 323, respectively, may be the largest in the unfolded state of the electronic device, and the area in which the first arm rail 412 and the second arm rail 422 are engaged with the second guide rail 313 and the fourth guide rail 323, respectively, may be the smallest in the folded state of the electronic device.

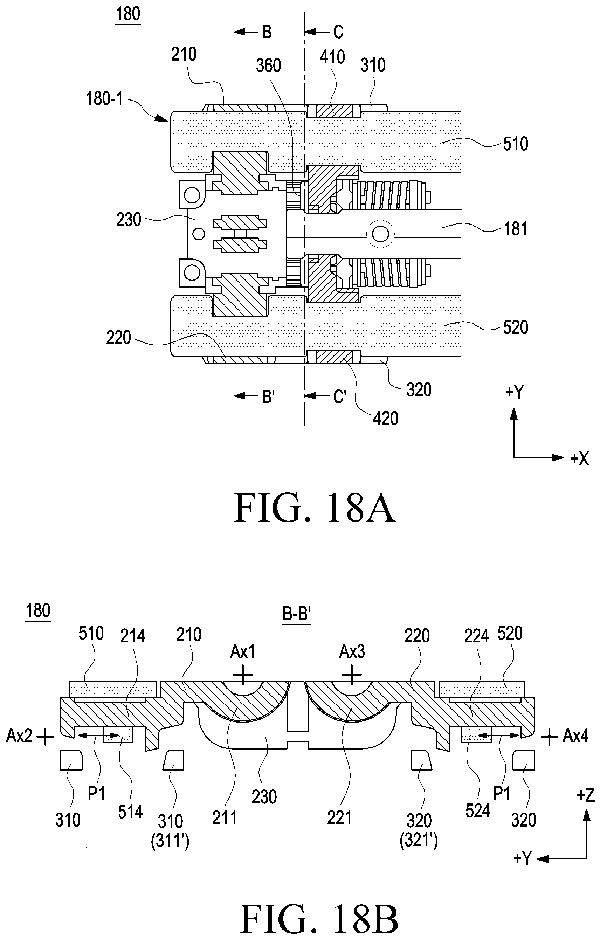

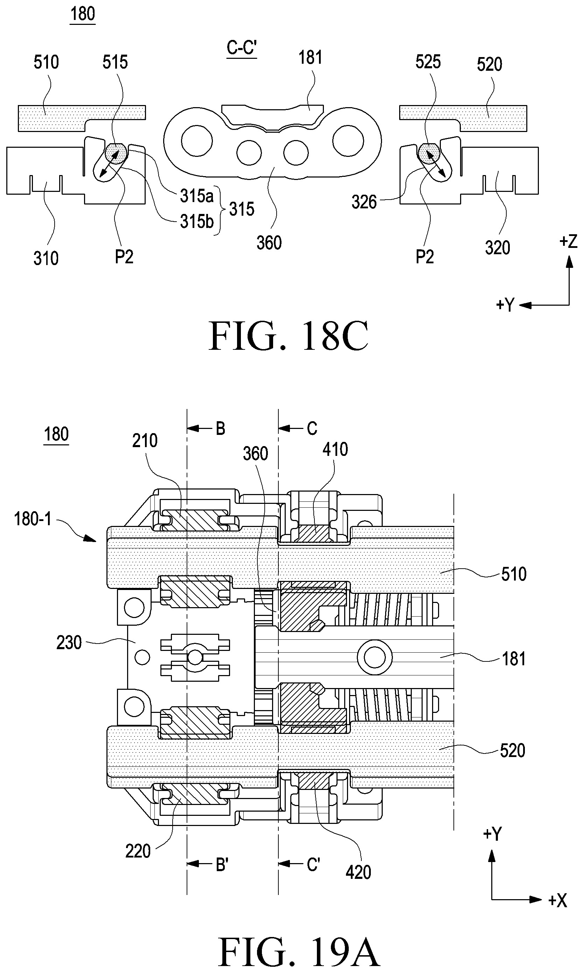

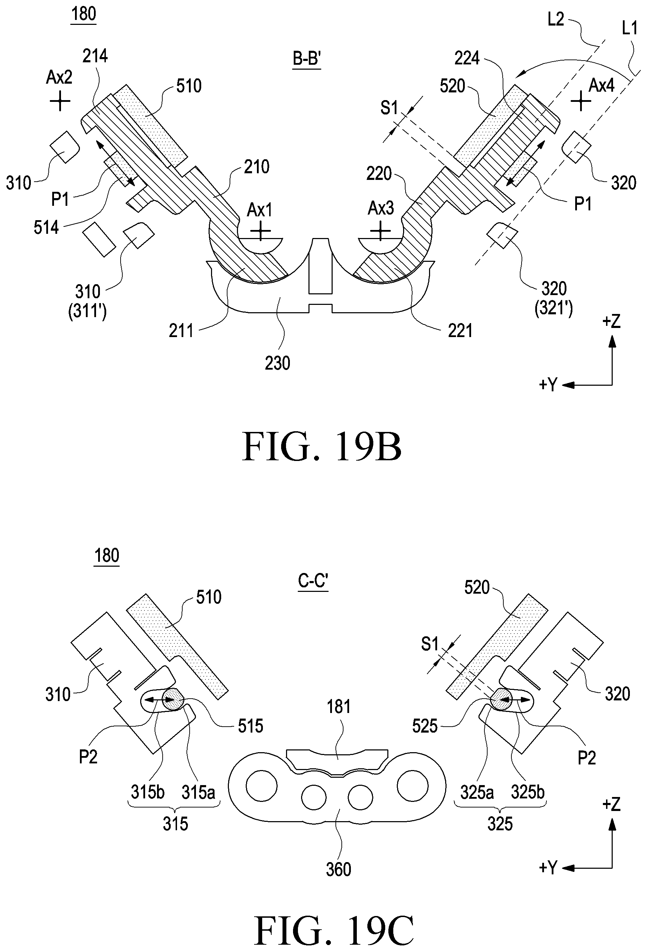

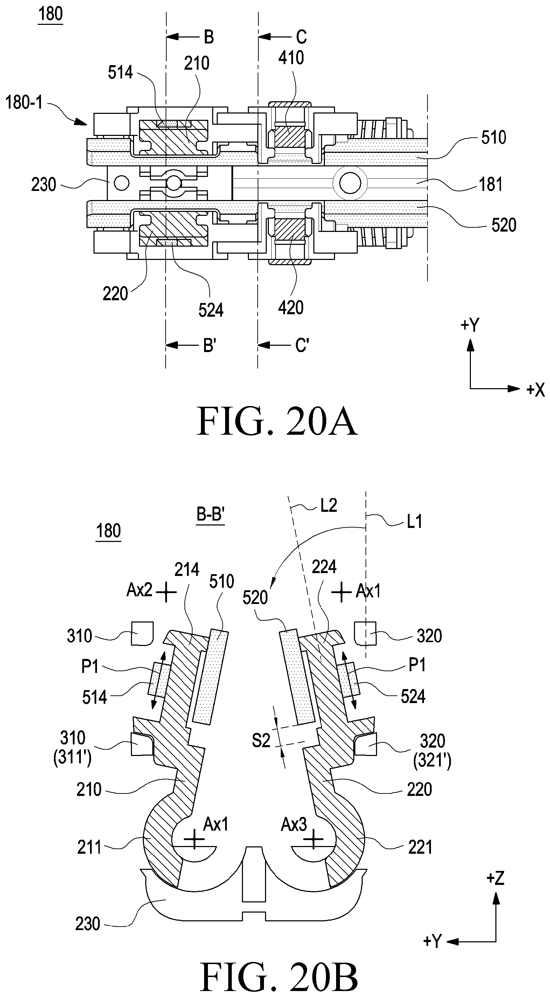

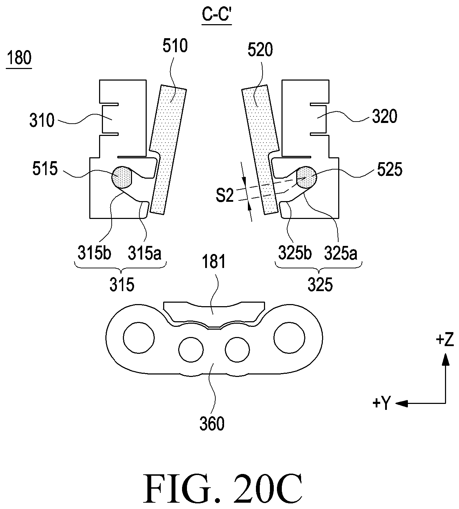

FIG. 18A is a view illustrating a hinge module in an unfolded state of an electronic device according to an embodiment of the disclosure. FIG. 18B may show a cross-section taken along direction B-B' of the hinge module of FIG. 18A according to an embodiment of the disclosure. FIG. 18C may show a cross-section taken along direction C-C' of the hinge module of FIG. 18A according to an embodiment of the disclosure. FIG. 19A is a view illustrating a hinge module when an electronic device is in an intermediate state between an unfolded state and a folded state according to an embodiment of the disclosure. FIG. 19B may show a cross-section taken along direction B-B' of the hinge module of FIG. 19A according to an embodiment of the disclosure. FIG. 19C may show a cross-section taken along direction C-C' of the hinge module of FIG. 19A according to an embodiment of the disclosure. FIG. 20A is a view illustrating a hinge module in a folded state of an electronic device according to an embodiment of the disclosure. FIG. 20B may show a cross-section taken along direction B-B' of the hinge module of FIG. 20A according to an embodiment of the disclosure. FIG. 20C may show a cross-section taken along direction C-C' of the hinge module of FIG. 20A according to an embodiment of the disclosure.

Referring to FIGS. 18A, 18B, 18C, 19A, 19B, 19C, 20A, 20B, and 20C, it is possible to understand the relative positions and motions of the first wing plate 510 and the second wing plate 520 with respect to the second connecting member 320, the first connecting member 310, and/or the second rotating member 220 and the first rotating member 210 while the electronic device switches from the unfolded state to the folded state (or from the folded state to the unfolded state). The sliding motion of the first wing plate 510 and the second wing plate, the rotating motion of the first rotating member 210 and the second rotating member 220 with respect to the first connecting member 310 and the second connecting member 320, and the leaned back motion of the first wing plate 510 and the second wing plate 520 during rotation are described in detail with reference to the embodiments of FIGS. 18A, 18B, 18C, 19A, 19B, 19C, 20A, 20B, and 20C. The leaned back motions of the first wing plate 510 and the second wing plate 520 are described with reference to the second protrusion 515 and the fifth protrusion 525 of FIG. 6, but the description may also be applied to the third protrusion 516 and the sixth protrusion 526. The first wing plate 510 and the second wing plate 520 may slide on the respective surfaces of the first rotating member 210 and the second rotating member 220. According to an embodiment, the first protrusion 514 and the fourth protrusion 524 may slide on the third rail 214 of the first rotating member 210 and the eighth rail 224 of the second rotating member 220, respectively, and as the first protrusion 514 and the fourth protrusion 524 slide along the first path P1, the first wing plate 510 and the second wing plate 520 may also move. Referring to FIGS. 18A and 18B, in the unfolded state of the electronic device, the first wing plate 510 and the second wing plate 520 may be disposed on the same plane. In the unfolded state of the electronic device, the first protrusion 514 and the fourth protrusion 524 may be positioned at one end portion of the first path P1. While the electronic device folds from the unfolded state, the first protrusion 514 and the fourth protrusion 524 may move from one end portion of the first path P1 toward the other end portion. Referring to FIGS. 19A and 19B, when the electronic device is in the intermediate state, the first wing plate 510 and the second wing plate 520 may be inclined with respect to each other by a predetermined angle. When the electronic device is in the intermediate state, the first protrusion 514 and the fourth protrusion 524 may be positioned in the middle of the first path P1. In this case, the angle formed by the first wing plate 510 and the second wing plate 520 may have a positive (+) value, and may move by the first distance S1 from the initial position in the unfolded state of the electronic device. Referring to FIGS. 20A and 20B, when the electronic device is in the folded state, the first wing plate 510 and the second wing plate 520 may be inclined with respect to each other by a predetermined angle. While the electronic device folds from the unfolded state, the first wing plate 510 and the second wing plate 520 may face each other in parallel in a specific intermediate state, and in the fully folded state, the angle formed by the first wing plate 510 and the second wing plate 520 may have a negative (-) value. Further, the first wing plate 510 and the second wing plate 520 may move by the second distance S2 from the initial position in the unfolded state of the electronic device. When the electronic device is in the folded state, the first protrusion 514 and the fourth protrusion 524 may be positioned at another end portion of the first path P1. Further, According to an embodiment, when the electronic device is in the folded state, one side of each of the first rotating member 210 and the second rotating member 220 may be supported by the supports 311' and 321' of the body portions included in the first connecting member 310 and the second connecting member 320.

The first wing plate 510 and the second wing plate 520, and the first rotating member 210 and the second rotating member 220 supporting the first wing plate 510 and the second wing plate 520 may rotate by a predetermined angle with respect to the first connecting member 310 and the second connecting member 320 when the electronic device switches from the unfolded state to the folded state. However, According to an embodiment, rather than rotating with respect to the first connecting member 310 and the second connecting member 320 as soon as the electronic device is switched from the unfolded state to the folded state, the first rotating member 210 and the second rotating member 220 may remain substantially parallel to the first connecting member 310 and the second connecting member 320 until the first wing plate 510 and the second wing plate 520 are inclined by a predetermined angle. Referring to FIGS. 18A and 18C, in the unfolded state of the electronic device, the first wing plate 510 and the second wing plate 520 may be disposed on the same plane, and the first wing plate 510 and the second wing plate 520 may be disposed parallel to the first connecting member 310 and the second connecting member 320, respectively. In the unfolded state of the electronic device, the second protrusion 515 and the fifth protrusion 525 may be positioned at one end portion of the second path P2. While the electronic device folds from the unfolded state, the second protrusion 515 and the fifth protrusion 525 may remain at the position until the electronic device is folded at a predetermined angle or less, rather than immediately moving to the other end portion from the one end portion of the second path P2. Referring to FIGS. 19A and 19C, when the electronic device is in the intermediate state, the first wing plate 510 and the second wing plate 520 may be inclined with respect to each other by a predetermined angle. As described above with reference to the embodiments of FIGS. 19A and 19B, the angle formed by the first wing plate 510 and the second wing plate 520 may have a positive (+) value, and they may move by a predetermined distance from the initial position in the unfolded state of the electronic device. However, relative positions of the first wing plate 510 and the second wing plate 520 with respect to the first connecting member 310 and the second connecting member 320 may remain the same as in the embodiments of FIGS. 18A and 18B. According to an embodiment, the fourth rail 315 may include a 4-1th rail 315a and a 4-2th rail 315b, and the ninth rail 325 may include a 9-1th rail 325a and a 9-2th rail 325b. According to an embodiment, the fourth rail 315 may include a 4-1th rail 315a for supporting the rotation of the second protrusion 515 according to the folding operation in a first angle range of the foldable electronic device, and a 4-2th rail 315b extending in one direction from the 4-1th rail 315a to support the sliding movement of the second protrusion 515 according to the folding operation in a second angle range of the foldable electronic device. The ninth rail 325 may include a 9-1th rail 325a for supporting rotation of the fifth protrusion 525 according to the folding operation in the first angle range of the foldable electronic device, and a 9-2th rail 325b extending in one direction from the 9-1th rail 325a to support the sliding movement of the fifth protrusion 525 according to the folding operation in the second angle range of the foldable electronic device. Here, the 4-2th rail 315b may be formed to be inclined with respect to the 4-1th rail 315a. Further, the 9-2th rail 325b may be formed to be inclined with respect to the 9-1th rail 325a. Referring to FIGS. 19A and 19C, while the electronic device switches from the unfolded state to the folded state, the second protrusion 515 may be positioned on the 4-1th rail 315a of the fourth rail 315 until the first wing plate 510 and the second wing plate 520 form a predetermined angle. The fifth protrusion 525 may be positioned on the 9-1th rail 325a of the ninth rail 325. When the electronic device is in the intermediate state, if the first wing plate 510 and the second wing plate 520 form a specific angle (e.g., if the first wing plate 510 and the second wing plate 520 move by the first distance S1), the second protrusion 515 and the fifth protrusion 525 may move along the second path P2. In this case, the second protrusion 515 and the fifth protrusion 525 may move on the 4-2th rail 315b of the fourth rail 315 and the 9-2th rail 325b of the ninth rail 325, respectively. Referring to FIGS. 20A and 20C, when the electronic device is in the folded state, the first wing plate 510 and the second wing plate 520 may be inclined to each other by a predetermined angle (e.g., have a negative (-) value). When the electronic device is in the folded state, the second protrusion 515 and the fifth protrusion 525 may be positioned at another end portion of the second path P2. Further, According to an embodiment, when the electronic device is in the folded state, one side of each of the first rotating member 210 and the second rotating member 220 may be supported by the supports 311' and 321' of the body portions included in the first connecting member 310 and the second connecting member 320.

As the electronic device switches from the unfolded state to the folded state, the first housing (e.g., the first housing 110 of FIG. 1) and the second housing (e.g., the second housing 120 of FIG. 2) (or the first supporting member 112 and the second supporting member 122 of FIG. 3) rotate about a folding axis (e.g., the folding axis of FIG. 1). In this case, the first connecting member 310 and the second connecting member 320 may also rotate at the same angle. Referring to FIGS. 18B, 18C, 19B, 19C, 20B, and 20C, when the electronic device switches from the unfolded state to the folded state, the first rotating member 210 and the second rotating member 220 are connected to the first connecting member 310 and the second connecting member 320 to rotate about the second axis Ax2 and the fourth axis Ax4, respectively, and the first rotating member 210 and the second rotating member 220 may be relatively rotated with respect to the first connecting member 310 and the second connecting member 320 (or the first supporting member 112 and the second supporting member 122), respectively. When the virtual line L1 drawn from the second connecting member 320 (or the first connecting member 310) is parallel to the second direction (+Z-axis direction) in the folded state of the electronic device, the virtual line L2 drawn from the first rotating member 210 (or the second rotating member 220) may be inclined from the L1 by a predetermined angle. The first wing plate 510 and the second wing plate 520 configured to linearly slide on the first rotating member 210 and the second rotating member 220 using the first protrusion 514 and the fourth protrusion 524 may also rotate at the same angle as the first rotating member 210 and the second rotating member 220. In this case, the first wing plate 510 and the second wing plate 520 may be connected to the fourth rail 315, the fifth rail 316, the ninth rail 325, and the tenth rail 326 formed in the first connecting member 310 and the second connecting member 320 using the second protrusion 515, the third protrusion 516, the fifth protrusion 525, and the sixth protrusion 526. The second protrusion 515, the third protrusion 516, the fifth protrusion 525, and the sixth protrusion 526 may be relatively close to the first supporting member 112 and the second supporting member 122 and may move away from the center of the hinge module 180 (see the gear bracket 360 or the center bar 181 of FIGS. 18C, 19C, and 20C).

The motion of the hinge module 180 as the electronic device switches from the unfolded state to the folded state may be implemented in the opposite direction when the electronic device switches from the folded state to the unfolded state.

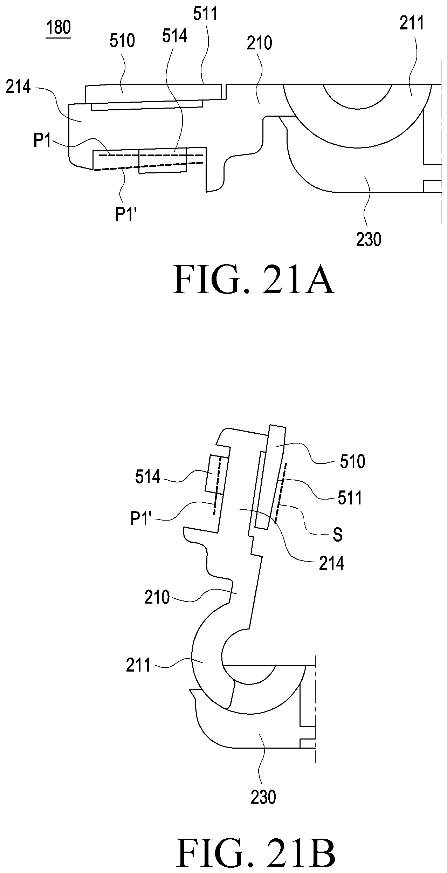

FIG. 21A is a view illustrating a hinge module in an unfolded state of an electronic device according to an embodiment of the disclosure. FIG. 21B is a view illustrating a hinge module in a folded state of an electronic device according to an embodiment of the disclosure.

FIGS. 21A and 21B may provide an embodiment of the third rail 214 included in the first rotating member 210 and the first protrusion 514 inserted therein to be slidable.

Referring to FIGS. 21A and 21B, the first seating surface 213 on which the third rail 214 according to an embodiment is formed may be formed to be inclined with respect to the upper surface 210c (e.g., the upper surface) of the first rotating member 210. According to an embodiment, since the first protrusion 514 inserted into the third rail 214 to be slidable moves along the inclined first seating surface 213, it may move along a 1-1th path P1' different from the first path P1, which is a movement path when the upper surface 210c of the first rotating member 210 and the first seating surface 213 are parallel to each other. The first path P1, which is the existing movement path, is formed so that the movement direction of the first wing plate 510 is parallel to the upper surface 210c of the first rotating member 210, and the 1-1st path P1', which is the other movement path, is formed so that the movement direction of the first wing plate 510 is not parallel to the upper surface 210c of the first rotating member 210. As described above, when the first seating surface 213 on which the third rail 214 is formed is formed to be inclined with respect to the upper surface 210c of the first rotating member 210, not only the first protrusion 514 but also the movement path of the first wing plate 510 may be inclined with respect to the upper surface 210c of the first rotating member 210. Accordingly, the first wing plate 510 may move away from the center of the hinge module 180 (e.g., see the gear bracket 360 or the center bar 181 of FIGS. 18C, 19C, and 20C) compared to the conventional one. In FIG. 21B, S indicated by a dot-single dashed line may indicate the position of the first wing plate 510 along the existing moving path. For example, according to an embodiment of the disclosure, as the first seating surface 213 is formed to be inclined with respect to the upper surface 210c of the first rotating member 210, the leaned back range of the first wing plate 510 may be increased. Accordingly, it is possible to further secure an escape space of the display required while the electronic device is folded.

The description made with reference to FIGS. 21A and 21 focuses primarily on the first rotating member 210 and the first wing plate 510, and may also apply to embodiments of the second rotating member 220 and the second wing plate 520.

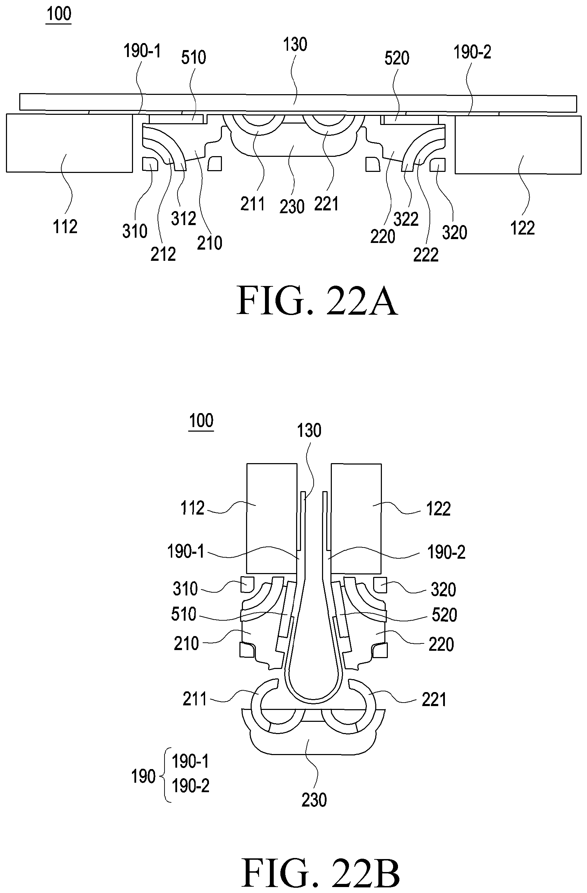

FIG. 22A is a view illustrating a hinge module in an unfolded state of an electronic device according to an embodiment of the disclosure. FIG. 22B is a view illustrating a hinge module in a folded state of an electronic device according to an embodiment of the disclosure.

The embodiments of FIGS. 22A and 22B may provide additional or alternative examples of a connection relationship between the first connecting member 310 and the second connecting member 320 and the first wing plate 510 and the second wing plate 520.

According to the above-described embodiments, the hinge module 180 may include the second protrusion 515 connecting the first wing plate 510 and the second wing plate 520 to the first connecting member 310 and the second connecting member 320, the third protrusion 516, the fifth protrusion 525, the sixth protrusion 526, the fourth rail 315, the fifth rail 316, the ninth rail 325, and the tenth rail 326. Referring to FIGS. 22A and 22B, according to an embodiment of the disclosure, additionally or alternatively to the above-described embodiments, there may be included flexible members 190-1 and 190-2 connecting the first wing plate 510 and the second wing plate 520 to the first supporting member 112 and the second supporting member 122, respectively. The flexible members 190-1 and 190-2 may be formed of, e.g., a material such as a tape, a rubber sheet, or a lattice metal structure having ductility (or elasticity). According to an embodiment, the first wing plate 510 and the second wing plate 520 may be attached to the first supporting member 112 and the second supporting member 122, respectively, using the flexible members 190-1 and 190-2. Accordingly, the first wing plate 510 and the second wing plate 520 may be pulled toward the first supporting member 112 and the second supporting member 122. Accordingly, it is possible to further secure an escape space of the display required while the electronic device is folded.

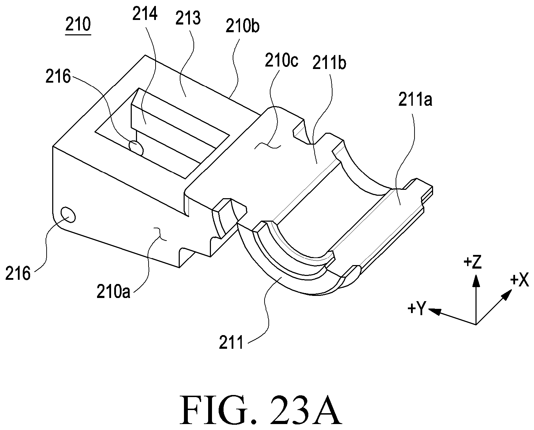

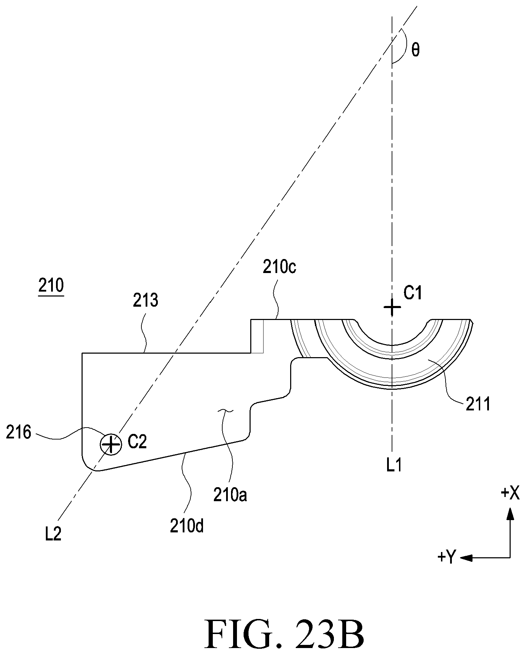

FIG. 23A is a perspective view illustrating a rotating member according to an embodiment of the disclosure. FIG. 23B is a front view illustrating a rotating member according to an embodiment of the disclosure.

Referring to FIGS. 23A and 23B, a rotating member (e.g., the first rotating member 210) may include two rotary elements (e.g., the first rail 211 and the first pin hole 216) configured to be rotatable about different axes. For example, when a surface of the first rotating member 210 facing in the second direction (+Z-axis direction) is referred to as an upper surface 210c, the first rotating member 210 may include a first rail 211 and a first pin hole 216 formed on the first side surface 210a facing in the width direction (X-axis direction) of the electronic device. According to an embodiment, the first rotating member 210 may also have a first rail 211 and a first pin hole 216 formed in the second side surface 210b facing in the width direction of the electronic device. The first rail 211 and the first pin hole 216 disposed in the first side surface 210a may be formed symmetrically with the first rail 211 and the first pin hole 216 disposed in the second side surface 210b with respect to a virtual line passing through the center of the first rotating member 210 in the length direction. According to an embodiment, in the hinge module 180, the first rail 211 may be disposed closer to a folding axis (e.g., the folding axis A of FIG. 1) than the first pin hole 216. According to an embodiment, the first rail 211 may have a convex shape in the first direction (-Z-axis direction), and the first pin hole 216 may have a shape through which a hole having a predetermined diameter passes in the width direction of the electronic device.

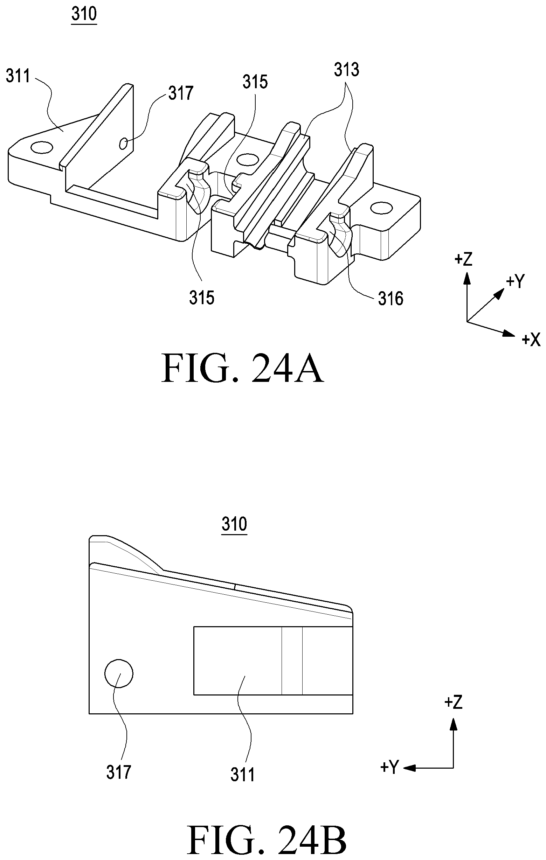

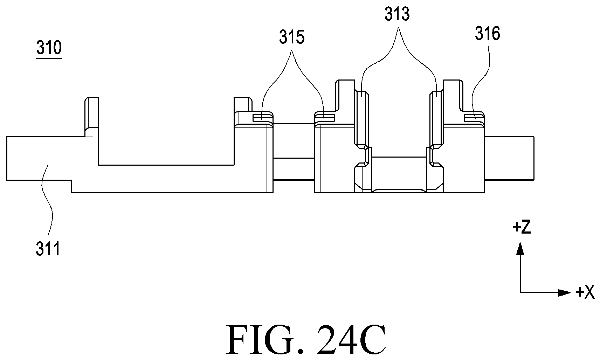

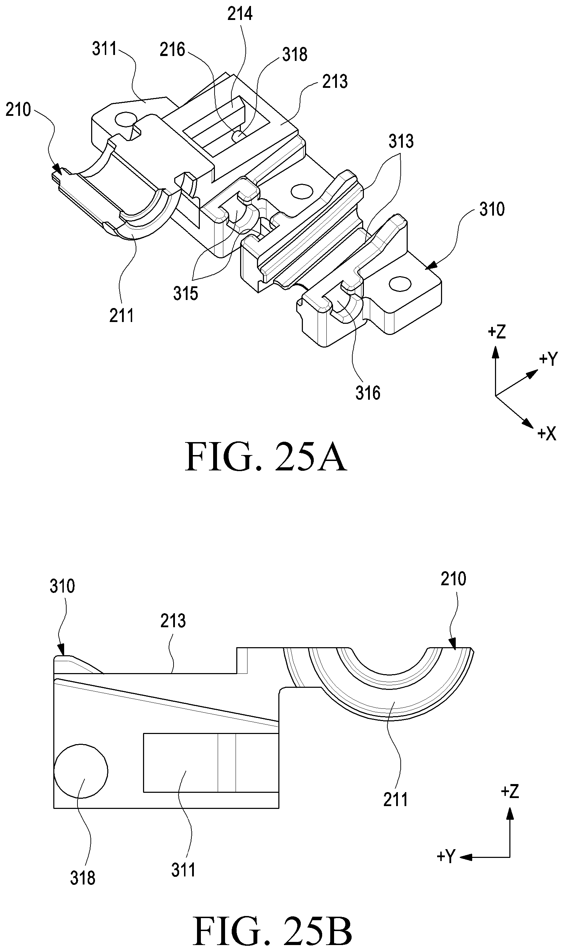

The first rail 211 may move along the rotating guide hole and may rotate about a first axis (e.g., the first axis Ax1 of FIG. 5). According to an embodiment, the first pin 318 illustrated in FIGS. 25A and 25B may be inserted into the first pin hole 216, and the rotating member 210 may be configured to rotate about the first pin hole 216 with respect to the connecting member 310 illustrated in FIGS. 24A, 24B, and 24C using the first pin 318. The first axis Ax1 and the second axis Ax2, which are the rotation centers of the first rail 211 and the first pin hole 216, may be formed at positions spaced apart from each other by a predetermined distance, and may not be formed on the same plane (e.g., the XY plane). Correspondingly, the first rail 211 and the first pin hole 216 of the first rotating member 210 may not be formed on the same plane (e.g., XY plane). For example, the first rail 211 may be formed adjacent to the upper surface 210c of the first rotating member 210, and the first pin hole 216 may be formed adjacent to the lower surface 210d of the first rotating member 210. In the foldable operation of the electronic device, the relative position of the first axis Ax1 of the first rotating member 210 may be fixed without being changed, and the position of the second axis Ax2 may be dependently changed by rotation of the first axis Ax1. According to an embodiment, when the electronic device is in the unfolded state, the second axis Ax2 of the first rotating member 210 may be formed at a position lower than the first axis Ax1, and when the electronic device is in the folded state, the second axis Ax2 of the first rotating member 210 may be formed at a position higher than the first axis Ax1. Further, the description of the rotating member made above with reference to FIGS. 8A to 8D may be applied to the description of the rotating member (e.g., the first rotating member 210) of FIGS. 23A and 23B, and descriptions in the overlapping range may be omitted.

According to an embodiment, the angle θ between the virtual line L1 connecting the center C1 of the arc of the first rail 211 to the center of the length of the arc and the virtual line L2 drawn from the center C2 of the first pin hole 216 may be formed, e.g., within 120 degrees to 240 degrees. For example, in FIG. 23B, the angle θ between the virtual lines L1 and L2 may be 135 degrees. However, the angular difference may vary according to embodiments.

The above description of the first rail 211 and the first pin hole 216 of the first rotating member 210 may be applied to the description of the sixth rail 221 and the third pin hole (not shown) of the second rotating member 220.

FIG. 24A is a perspective view illustrating a connecting member according to an embodiment of the disclosure. FIG. 24B is a view illustrating a second pin hole of a connecting member according to an embodiment of the disclosure. FIG. 24C is a side view illustrating a connecting member according to an embodiment of the disclosure. FIG. 25A is a perspective view illustrating a state in which a rotating member is coupled to a connecting member according to an embodiment of the disclosure. FIG. 25B is a front view illustrating a state in which a rotating member is coupled to a connecting member according to an embodiment of the disclosure.

Referring to FIGS. 24A, 24B, 24C, a connecting member (e.g., the first connecting member 310) may include a body portion (e.g., the first body portion 311) and two rotary elements (e.g., the second pin hole 317 and the second guide rail 313) formed to be spaced apart from each other by a predetermined distance along the length direction of the body portion 311. According to an embodiment, the first connecting member 310 may be fixedly coupled to a supporting member (e.g., the first supporting member 112 of FIG. 3) on the lower surface of the first body portion 311, and may be fastened to each of the first rotating member 210 and the first arm member 410 on the upper surface of the first body portion 311. FIGS. 25A and 25B may illustrate a state in which only the first rotating member 210 is coupled to the upper surface of the first body portion 311 of the first connecting member 310.

Referring to FIGS. 24A, 24B, 24C, 25A, and 25B, when the first rotating member 210 and the first connecting member 310 are coupled, the first pin hole 216 of the first rotating member 210 may be aligned with the second pin hole 317 of the first connecting member 310. According to an embodiment, the first pin 318 may be inserted into the first pin hole 216 and the second pin hole 317. The first pin 318 may correspond to a rotary element that guides the first rotating member 210 to rotate along an axis (e.g., the second axis Ax2 of FIG. 7).

Further, the description of the connecting member made above with reference to FIGS. 9A, 9B, and 9C may be applied to the description of the connecting member (e.g., the first connecting member 310) of FIGS. 23A, 23B, 24A, 24B, 24C, 25A, and 25B, and descriptions in the overlapping range may be omitted. The description of the first body portion 311, the second pin hole 317, the second guide rail 313, the fourth rail 315, and the fifth rail 316 of the first connecting member 310 may be applied to the description of the second body portion 321, the fourth pin hole rail (not shown), the fourth guide rail 323, the ninth rail 325, and the tenth rail 326 of the second connecting member 320.

According to an embodiment of the disclosure, a foldable electronic device 100 may be provided. The foldable electronic device may include a first housing 110, a second housing 120, a hinge module 180 rotatably coupling the first housing and the second housing about a folding axis A, and a flexible display 130. The hinge module 180 may include a first rotating member including a first rotary element configured to rotate about a first axis Ax1, a second rotary element configured to rotate about a second axis Ax2, and a reciprocating element 214 configured to linearly reciprocate at least a portion of a first wing plate in a direction perpendicular to the first axis and the second axis, a first arm member configured to rotate about an axis different from the first axis and the second axis in response to rotation about the first axis, a first connecting member connecting the first rotating member and the first arm member. The first wing plate is positioned to cover at least a portion of the first rotating member and the first arm member and configured to rotate according to a folding operation of the foldable electronic device.

According to an embodiment, the first rotating member may a first rail (211) configured to rotate about the first axis (Ax1) and shaped to be convex in a first direction, a second rail (212) configured to rotate about the second axis (Ax2) and shaped to be convex in a second direction different from the first direction, and a third rail (214) having an opening shape.

According to an embodiment, the first rotating member may include a first rail (211) configured rotate about the first axis (Ax1) and shaped to be convex in a first direction, a first pin hole (216) formed on the second axis (Ax2), and a third rail (214) having an opening shape.

According to an embodiment of the disclosure, a foldable electronic device 100 including the hinge module 180 may be provided. The foldable electronic device may include a first housing 110, a second housing 120, a hinge module 180 rotatably coupling the first housing and the second housing about a folding axis A, and a flexible display 130. The hinge module 180 may include a first rotating member 210 including a first rail 211 configured to rotate about a first axis Ax1 and shaped to be convex in a first direction, a second rail 212 configured to rotate about a second axis Ax2 and shaped to be convex in a second direction different from the first direction, and a third rail 214 having an opening shape, a first arm member configured to rotate about an axis different from the first axis and the second axis in response to the rotation about the first axis, a first connecting member configured to connect the first rotating member and the first arm member, and a first wing plate positioned to cover at least a portion of the first rotating member and the first arm member and configured to rotate according to a folding operation of the foldable electronic device.

According to an embodiment, the first wing plate may include a first protrusion configured to slide according to the folding operation of the foldable electronic device to correspond to the third rail.

According to an embodiment, the first wing plate may include a second protrusion. The first connecting member may include a fourth rail configured to guide the second protrusion to slide according to the folding operation of the foldable electronic device corresponding to the second protrusion.

According to an embodiment, the fourth rail may include a 4-1th rail supporting rotation of the second protrusion according to the folding operation in a first angle range of the foldable electronic device, and a 4-2th rail extending in one direction from the 4-1th rail 315a and supporting a sliding movement of the second protrusion 515 according to the folding operation in a second angle range of the foldable electronic device.

According to an embodiment, the foldable electronic device may further comprise a rotating bracket 230 including a first rotating guide hole configured to rotate the first rail of the first rotating member.

According to an embodiment, the first rotating guide hole may be defined by a space between a 1-1th opening formed in one side of the rotating bracket and the 1-2th opening formed in another side of the rotating bracket.

According to an embodiment, the first connecting member may include a first guide rail configured to guide the second rail of the first rotating member.

According to an embodiment, the first arm member may include a first cam portion configured to rotate in response to the rotation about the first axis and a first arm rail configured to slide in response to rotation of the first cam portion.

According to an embodiment, the first connecting member may include a second guide rail configured to guide the first arm rail of the first arm member.

According to an embodiment, the first connecting member may be coupled onto a first supporting member disposed in the first housing.

According to an embodiment, the foldable electronic device may further comprise a first flexible member 190-1 connecting the first connecting member and the first supporting member.

According to an embodiment, the first wing plate may be seated on a first seating surface 213 of the first rotating member, and be configured so that the first protrusion moves on the third rail and slide in a direction parallel to the first seating surface according to the folding operation of the foldable electronic device.

According to an embodiment, the first seating surface may be formed to be inclined by a predetermined angle with respect to an upper surface of the first rotating member so that the first wing plate slides in a direction inclined with respect to the upper surface of the first rotating member.

According to an embodiment, the first wing plate may include a third protrusion. The first connecting member may include a fifth rail configured to guide the third protrusion to slide according to the folding operation of the foldable electronic device corresponding to the third protrusion.

According to an embodiment, the foldable electronic device may further comprise a gear member 350. The gear member may include a shaft 351; 352 forming an interlocking axis Rx1; Rx2 for rotating the arm member and a gear 353; 354 positioned at an end portion of the shaft.

According to an embodiment of the disclosure, a hinge module 180 may be provided. A hinge module may comprise a first rotating member including a first rail 211 configured to rotate about a first axis Ax1 and shaped to be convex in a first direction, one of a second rail 212 configured to rotate about a second axis Ax2 and shaped to be convex in a second direction different from the first direction, or a first pin hole 216 formed on the second axis, and a third rail 214 having an opening shape, a rotating bracket including a first rotating guide hole configured to guide the first rail, a first arm member including a first cam portion configured to rotate about an axis different from the first axis and the second axis in response to rotation about the first axis and a first arm rail 412 configured to slide in response to the rotation of the first cam portion, a first connecting member including a first guide rail configured to guide the second rail or a second pin hole 317 aligned with the first pin hole 216, a second guide rail 313 configured to guide the first arm rail, and a fourth rail 315, and a first wing plate positioned to cover at least a portion of the first rotating member and the first arm member and including a first protrusion configured to slide on the third rail and a second protrusion 515 configured to slide on the fourth rail.

According to an embodiment of the disclosure, a hinge module 180 may be provided. A hinge module may comprise a first rotating member including a first rail 211 configured to rotate about a first axis Ax1 and shaped to be convex in a first direction, a second rail 212 configured to rotate about a second axis Ax2 and shaped to be convex in a second direction different from the first direction, and a third rail 214 having an opening shape, a rotating bracket including a first rotating guide hole configured to guide the first rail, a first arm member including a first cam portion configured to rotate about an axis different from the first axis and the second axis in response to rotation about the first axis and a first arm rail 412 configured to slide in response to the rotation of the first cam portion, a first connecting member including a first guide rail configured to guide the second rail, a second guide rail 313 guiding the first arm rail, and a fourth rail 315, and a first wing plate positioned to cover at least a portion of the first rotating member and the first arm member and including a first protrusion 514 configured to slide on the third rail and a second protrusion 515 configured to slide on the fourth rail.

According to an embodiment, the first connecting member may be coupled onto a first supporting member.

According to an embodiment, the first wing plate may be seated on a first seating surface 213 of the first rotating member, and be configured so that the first protrusion moves on the third rail and slide in a direction parallel to the first seating surface according to the folding operation of the foldable electronic device.

According to an embodiment of the disclosure, a foldable electronic device 100 including the hinge module 180 may be provided. The foldable electronic device may include a first housing 110, a second housing 120, a hinge module 180 rotatably coupling the first housing and the second housing about a folding axis A, and a flexible display 130. The hinge module 180 may include a first rotating member including a first rail 211 configured to rotate about a first axis Ax1 and shaped to be convex in a first direction, one of a second rail 212 configured to rotate about a second axis Ax2 and shaped to be convex in a second direction different from the direction rail, or a first pin hole 216 formed on the second axis, and a third rail 214 having an opening shape, a second rotating member including a sixth rail rotating about a third axis Ax3 and shaped to be convex in a third direction, one of a seventh rail 222 configured to rotate about a fourth axis Ax4 and shaped to be convex in a fourth direction different from the third direction, or a third pin hole formed on the fourth axis, and an eighth rail 224 having an opening shape, a first arm member configured to rotate about an axis different from the first axis and the second axis in response to rotation about the first axis, a second arm member configured to rotate about an axis different from the third axis and the fourth axis in response to rotation about the third axis, a first connecting member configured to connect the first rotating member and the first arm member, a second connecting member configured to connect the second rotating member and the second arm member, a first wing plate positioned to cover at least a portion of the first rotating member and the first arm member and configured to rotate according to a folding operation of the foldable electronic device, and a second wing plate positioned to cover at least a portion of the second rotating member and the second arm member and configured to rotate according to the folding operation of the foldable electronic device.

According to an embodiment of the disclosure, a foldable electronic device 100 including the hinge module 180 may be provided. The foldable electronic device may include a first housing 110, a second housing 120, a hinge module 180 rotatably coupling the first housing and the second housing about a folding axis A, and a flexible display 130. The hinge module 180 may include a first rotating member including a first rail configured to rotate about a first axis Ax1 and shaped to be convex in a first direction, a second rail 212 configured to rotate about a second axis Ax2 and shaped to be convex in a second direction different from the first direction, and a third rail 214 having an opening shape, a second rotating member including a sixth rail rotating about a third axis Ax3 and shaped to be convex in a third direction, a seventh rail 222 configured to rotate about a fourth axis Ax4 and shaped to be convex in a fourth direction different from the third direction and an eighth rail 224 having an opening shape, a first arm member configured to rotate about an axis different from the first axis and the second axis in response to rotation about the first axis, a second arm member configured to rotate about an axis different from the third axis and the fourth axis in response to rotation about the third axis, a first connecting member configured to connect the first rotating member and the first arm member, a second connecting member configured to connect the second rotating member and the second arm member, a first wing plate positioned to cover at least a portion of the first rotating member and the first arm member and configured to rotate according to a folding operation of the foldable electronic device, and a second wing plate positioned to cover at least a portion of the second rotating member and the second arm member and configured to rotate according to the folding operation of the foldable electronic device.

According to an embodiment, the first wing plate may include a first protrusion configured to slide according to the folding operation of the foldable electronic device corresponding to the third rail and a second protrusion configured to slide according to the folding operation of the foldable electronic device corresponding to a fourth rail 315 of the connecting member, and the first wing plate may include a fourth protrusion configured to slide according to the folding operation of the foldable electronic device corresponding to the eighth rail and a fifth protrusion configured to slide according to the folding operation of the foldable electronic device corresponding to a ninth rail 325 of the connecting member.

According to an embodiment, the first connecting member may include a first guide rail configured to guide a second pin hole aligned with the first pin hole of the first rotating member.

According to an embodiment, the first cam portion may be configured to rotate about an axis different from the first axis and the second axis in response to the rotation about the first axis.

While the disclosure has been described and shown in connection with various embodiments, it should be appreciated that various embodiments are intended as limiting the invention but as illustrative. It will be apparent to one of ordinary skill in the art that various changes may be made in form and detail without departing from the overall scope of the disclosure, including the appended claims and their equivalents.

## Claims

1. A foldable electronic device (100) comprising:
a first housing (110);
a second housing (120);
a hinge module (180) rotatably coupling the first housing and the second housing about a folding axis (A); and
a flexible display (130),
wherein the hinge module (180) includes:
a first rotating member (210) including a first rotary element (211) configured to rotate about a first axis (Ax1), a second rotary element (212; 216) configured to rotate about a second axis (Ax2), and a reciprocating element (214) configured to linearly reciprocate at least a portion of a first wing plate in a direction perpendicular to the first axis and the second axis,
a first arm member (410) configured to rotate about an axis different from the first axis and the second axis in response to rotation about the first axis,
a first connecting member (310) connecting the first rotating member and the first arm member, and
the first wing plate positioned to cover at least a portion of the first rotating member and the first arm member and configured to rotate according to a folding operation of the foldable electronic device.

2. The foldable electronic device of claim 1, wherein the first rotating member includes:
a first rail (211) configured to rotate about the first axis (Ax1) and shaped to be convex in a first direction, a second rail (212) configured to rotate about the second axis (Ax2) and shaped to be convex in a second direction different from the first direction, and a third rail (214) having an opening shape.

3. The foldable electronic device of claim 2, wherein the first connecting member includes a first guide rail configured to guide the second rail of the first rotating member.

4. The foldable electronic device of claim 1, wherein the first rotating member includes a first rail (211) configured rotate about the first axis (Ax1) and shaped to be convex in a first direction, a first pin hole (216) formed on the second axis (Ax2), and a third rail (214) having an opening shape.

5. The foldable electronic device of claims 2 or 4, wherein the first wing plate includes a first protrusion (514) configured to slide according to the folding operation of the foldable electronic device to correspond to the third rail.

6. The foldable electronic device of claim 5,
wherein the first wing plate is seated on a first seating surface(213) of the first rotating member, and
wherein the first wing plate is configured so that the first protrusion moves on the third rail and slides in a direction parallel to the first seating surface according to the folding operation of the foldable electronic device.

7. The foldable electronic device of claim 6, wherein the first seating surface is formed to be inclined by a predetermined angle with respect to an upper surface(210c) of the first rotating member so that the first wing plate slides in a direction inclined with respect to the upper surface(210c) of the first rotating member.

8. The foldable electronic device of any one of claims 1 to 7,
wherein the first wing plate includes a second protrusion (515), and
wherein the first connecting member includes a fourth rail (315) configured to guide the second protrusion to slide according to the folding operation of the foldable electronic device corresponding to the second protrusion.

9. The foldable electronic device of claim 8,
wherein the fourth rail includes:
a 4-1th rail (315a) supporting rotation of the second protrusion according to the folding operation in a first angle range of the foldable electronic device, and a 4-2th rail (315b) extending in one direction from the 4-1th rail (315a) and supporting a sliding movement of the second protrusion (515) according to the folding operation in a second angle range of the foldable electronic device.

10. The foldable electronic device of any one of claims 1 to 9,
wherein the first wing plate includes a third protrusion(516), and
wherein the first connecting member includes a fifth rail configured to guide the third protrusion to slide according to the folding operation of the foldable electronic device corresponding to the third protrusion.

11. The foldable electronic device of any one of claims 1 to 10, further comprising:
a rotating bracket(230) including a first rotating guide hole configured to guide the first rail of the first rotating member.

12. The foldable electronic device of claim 11, wherein the first rotating guide hole is defined by a space between a 1-1th opening (233) formed in one side of the rotating bracket and a 1-2th opening (234) formed in another side of the rotating bracket.

13. The foldable electronic device of any one of claims 1 to 12, wherein the first arm member includes:
a first cam portion (411) configured to rotate in response to the rotation about the first axis and a first arm rail (412) configured to slide in response to the rotation of the first cam portion.

14. The foldable electronic device of claim 13, wherein the first connecting member includes a second guide rail (313) configured to guide the first arm rail (412) of the first arm member.

15. The foldable electronic device of any one of claims 1 to 14, wherein the first connecting member is coupled onto a first supporting member disposed in the first housing.
